# EUROPEAN PATENT APPLICATION

(11) **EP 4 827 287 A1**
(43) Date of publication of application: **21.10.2026**
(21) Application number: 24903334.1
(22) Date of filing: 18.10.2024
(51) Int. Cl.: H10K 30/60, H04N 25/70, H10F 30/20, H10F 39/18, H10K 30/20, H10K 30/30

(54) **LIGHT DETECTOR AND ELECTRONIC DEVICE**

(30) Priority: 13.12.2023 JP 2023210156
(71) Applicant: Sony Semiconductor Solutions Corporation, Atsugi-shi, Kanagawa 243-0014 (JP)
(72) Inventor: TAKAGUCHI, Ryotaro, Atsugi-shi, Kanagawa 243-0014 (JP); IMAJO, Toshifumi, Atsugi-shi, Kanagawa 243-0014 (JP); JOEI, Masahiro, Atsugi-shi, Kanagawa 243-0014 (JP); YAGI, Iwao, Atsugi-shi, Kanagawa 243-0014 (JP); MURAMATSU, Shogo, Atsugi-shi, Kanagawa 243-0014 (JP)
(74) Representative: Müller Hoffmann & Partner
(86) International application number: PCT/JP2024/037145
(87) International publication number: WO 2025/126671

(57) **Abstract**

A light detecting device (1) according to an embodiment of the present disclosure includes: a first electrode (23); a second electrode (26) provided to be opposed to the first electrode (23); a photoelectric conversion film (22) provided between the first electrode (23) and the second electrode (26); a first semiconductor layer (25a) provided between the photoelectric conversion film (22) and the second electrode (26); and a second semiconductor layer (25b) provided between the first semiconductor layer (25a) and the second electrode (26). A difference between a Fermi level and an energy level at a conduction band lower end in the first semiconductor layer (25a) is smaller than a difference between a Fermi level and an energy level at a conduction band lower end in the second semiconductor layer (25b).

## Description

### Technical Field

The present disclosure relates to a light detecting device and an electronic apparatus.

### Background Art

An imaging device has been proposed that includes a plurality of photoelectric conversion layers and that photoelectrically converts light beams of respective colors (PTL 1).

### Citation List

### Patent Literature

PTL 1: Japanese Unexamined Patent Application Publication No. 2017-157816

### Summary of the Invention

A device that detects light is required to suppress a decrease in signal quality.

It is desirable to provide a light detecting device that makes it possible to suppress a decrease in signal quality.

A light detecting device according to an embodiment of the present disclosure includes: a first electrode; a second electrode provided to be opposed to the first electrode; a photoelectric conversion film provided between the first electrode and the second electrode; a first semiconductor layer provided between the photoelectric conversion film and the second electrode; and a second semiconductor layer provided between the first semiconductor layer and the second electrode. A difference between a Fermi level and an energy level at a conduction band lower end in the first semiconductor layer is smaller than a difference between a Fermi level and an energy level at a conduction band lower end in the second semiconductor layer.

An electronic apparatus according to an embodiment of the present disclosure includes: an optical system; and a light detecting device that receives light transmitted through the optical system. The light detecting device includes a first electrode, a second electrode provided to be opposed to the first electrode, a photoelectric conversion film provided between the first electrode and the second electrode, a first semiconductor layer provided between the photoelectric conversion film and the second electrode, and a second semiconductor layer provided between the first semiconductor layer and the second electrode. A difference between a Fermi level and an energy level at a conduction band lower end in the first semiconductor layer is smaller than a difference between a Fermi level and an energy level at a conduction band lower end in the second semiconductor layer.

### Brief Description of the Drawings

[FIG. 1] FIG. 1 is a block diagram illustrating an example of a schematic configuration of an imaging device which is an example of a light detecting device according to a first embodiment of the present disclosure.
[FIG. 2] FIG. 2 is a diagram illustrating an example of a pixel section of the imaging device according to the first embodiment of the present disclosure.
[FIG. 3] FIG. 3 is an explanatory diagram of an example of a cross-sectional configuration of the imaging device according to the first embodiment of the present disclosure.
[FIG. 4] FIG. 4 is an explanatory diagram of an example of a circuit configuration of a pixel of the imaging device according to the first embodiment of the present disclosure.
[FIG. 5] FIG. 5 is an explanatory diagram of an example of a planar configuration of the imaging device according to the first embodiment of the present disclosure.
[FIG. 6] FIG. 6 is an explanatory diagram of a configuration example of the imaging device according to the first embodiment of the present disclosure.
[FIG. 7] FIG. 7 is a diagram illustrating an example of energy levels in the imaging device according to the first embodiment of the present disclosure.
[FIG. 8A] FIG. 8A is an explanatory diagram of an example of a method of manufacturing the imaging device according to the first embodiment of the present disclosure.
[FIG. 8B] FIG. 8B is an explanatory diagram of an example of the method of manufacturing the imaging device according to the first embodiment of the present disclosure.
[FIG. 8C] FIG. 8C is an explanatory diagram of an example of the method of manufacturing the imaging device according to the first embodiment of the present disclosure.
[FIG. 8D] FIG. 8D is an explanatory diagram of an example of the method of manufacturing the imaging device according to the first embodiment of the present disclosure.
[FIG. 9] FIG. 9 is an explanatory diagram of another configuration example of the imaging device according to the first embodiment of the present disclosure.
[FIG. 10] FIG. 10 is a diagram illustrating an example of energy levels in the imaging device according to the first embodiment of the present disclosure.
[FIG. 11] FIG. 11 is a timing chart illustrating an operation example of the imaging device according to the first embodiment of the present disclosure.
[FIG. 12] FIG. 12 is an explanatory diagram of an example of a cross-sectional configuration of an imaging device according to Modification Example 1 of the present disclosure.
[FIG. 13] FIG. 13 is an explanatory diagram of an example of a planar configuration of the imaging device according to Modification Example 1 of the present disclosure.
[FIG. 14] FIG. 14 is an explanatory diagram of another configuration example of the imaging device according to Modification Example 1 of the present disclosure.
[FIG. 15] FIG. 15 is an explanatory diagram of another configuration example of the imaging device according to Modification Example 1 of the present disclosure.
[FIG. 16] FIG. 16 is an explanatory diagram of an example of a cross-sectional configuration of an imaging device according to Modification Example 2 of the present disclosure.
[FIG. 17] FIG. 17 is a diagram illustrating an example of energy levels in the imaging device according to Modification Example 2 of the present disclosure.
[FIG. 18] FIG. 18 is an explanatory diagram of an example of a cross-sectional configuration of an imaging device according to Modification Example 3 of the present disclosure.
[FIG. 19] FIG. 19 is a diagram illustrating an example of energy levels in the imaging device according to Modification Example 3 of the present disclosure.
[FIG. 20] FIG. 20 is an explanatory diagram of a configuration example of an imaging device according to Modification Example 4 of the present disclosure.
[FIG. 21] FIG. 21 is an explanatory diagram of a configuration example of an imaging device according to Modification Example 5 of the present disclosure.
[FIG. 22] FIG. 22 is an explanatory diagram of a configuration example of an imaging device according to Modification Example 6 of the present disclosure.
[FIG. 23A] FIG. 23A is an explanatory diagram of a configuration example of the imaging device according to Modification Example 6 of the present disclosure.
[FIG. 23B] FIG. 23B is an explanatory diagram of a configuration example of the imaging device according to Modification Example 6 of the present disclosure.
[FIG. 24] FIG. 24 is an explanatory diagram of a configuration example of an imaging device according to a second embodiment of the present disclosure.
[FIG. 25] FIG. 25 is a diagram illustrating an example of energy levels in the imaging device according to the second embodiment of the present disclosure.
[FIG. 26] FIG. 26 is an explanatory diagram of another configuration example of the imaging device according to the second embodiment of the present disclosure.
[FIG. 27] FIG. 27 is a diagram illustrating an example of the energy levels in the imaging device according to the second embodiment of the present disclosure.
[FIG. 28A] FIG. 28A is an explanatory diagram of an example of a cross-sectional configuration of an imaging device according to Modification Example 7 of the present disclosure.
[FIG. 28B] FIG. 28B is an explanatory diagram of an example of the cross-sectional configuration of the imaging device according to Modification Example 7 of the present disclosure.
[FIG. 29] FIG. 29 is an explanatory diagram of an example of a cross-sectional configuration of an imaging device according to Modification Example 8 of the present disclosure.
[FIG. 30] FIG. 30 is a diagram illustrating an example of energy levels in the imaging device according to Modification Example 8 of the present disclosure.
[FIG. 31] FIG. 31 is a block diagram illustrating a configuration example of an electronic apparatus.
[FIG. 32A] FIG. 32A schematically illustrates an example of an overall configuration of a light detecting system.
[FIG. 32B] FIG. 32B schematically illustrates an example of an overall configuration of the light detecting system.
[FIG. 33] FIG. 33 is a block diagram depicting an example of schematic configuration of a vehicle control system.
[FIG. 34] FIG. 34 is a diagram of assistance in explaining an example of installation positions of an outside-vehicle information detecting section and an imaging section.
[FIG. 35] FIG. 35 is a view depicting an example of a schematic configuration of an endoscopic surgery system.
[FIG. 36] FIG. 36 is a block diagram depicting an example of a functional configuration of a camera head and a camera control unit (CCU).

### Modes for Carrying Out the Invention

Hereinafter, description is given in detail of embodiments of the present disclosure with reference to the drawings. It is to be noted that the description is given in the following order.
1. First Embodiment
2. Second Embodiment
3. Application Examples
4. Practical Application Examples

### <1. First Embodiment>

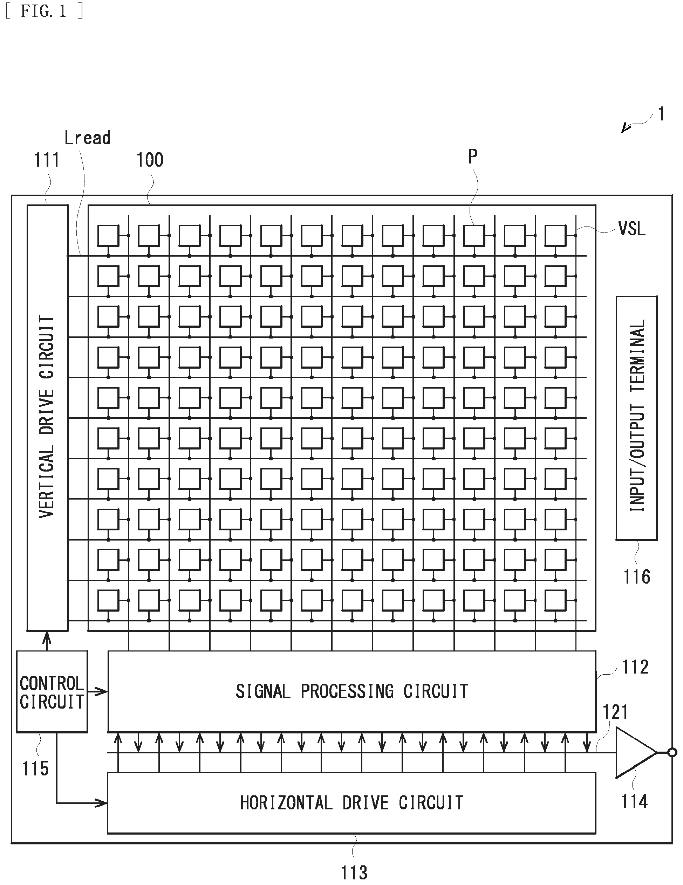

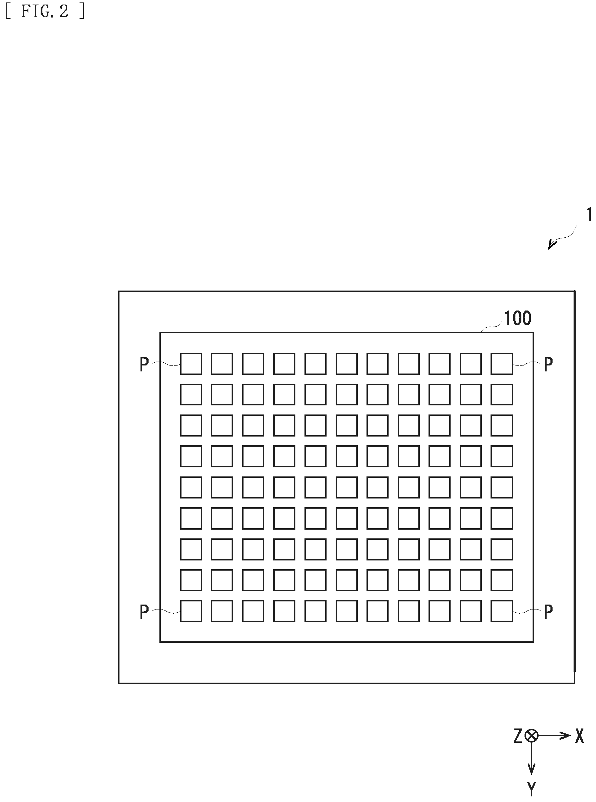

FIG. 1 is a block diagram illustrating an example of a schematic configuration of an imaging device which is an example of a light detecting device according to a first embodiment of the present disclosure. FIG. 2 is a diagram illustrating an example of a pixel section of the imaging device according to the first embodiment. The light detecting device is a device that is able to detect incident light. An imaging device 1, which is an example of a light detecting device, includes a plurality of pixels P each including a photoelectric conversion section (photoelectric conversion element), and is configured to photoelectrically convert incident light and generate a signal. For example, the imaging device 1 may receive light transmitted through an optical system (unillustrated) including an optical lens and generate a signal.

The imaging device 1 is configured using, for example, a semiconductor substrate provided with the plurality of pixels P. Each of the pixels P of the imaging device 1 includes, for example, a photodiode (PD) as a photoelectric conversion section, and is configured to be able to photoelectrically convert light. As in the example illustrated in FIG. 2, the imaging device 1 includes, as an imaging area, a region (a pixel section 100) in which the plurality of pixels P is two-dimensionally arranged in matrix. The pixel section 100 may also be referred to as a pixel array in which the plurality of pixels P is arranged.

The imaging device 1 takes in incident light (image light) from a subject, which is a measurement target, via the optical system including the optical lens. The imaging device 1 captures an image of the subject formed by the optical lens. The imaging device 1 may photoelectrically convert received light (e.g., visible light, infrared light, etc.) and generate a pixel signal. The imaging device 1, which is a light detecting device, is a device that is able to receive incident light and generate a signal. The imaging device 1 may also be referred to as a light-receiving device.

As an example, the imaging device 1 (light detecting device) may be configured as an image sensor. The imaging device 1 is, for example, a CMOS (Complementary Metal Oxide Semiconductor) image sensor. The imaging device 1 may have a structure (stacked structure) configured by stacking a plurality of semiconductor layers. The imaging device 1 is usable for various electronic apparatuses such as a digital still camera, a video camera, and a mobile phone.

It is to be noted that, as illustrated in FIG. 2, a direction in which light from the subject is incident is defined as a Z-axis direction; a right-left direction on the sheet orthogonal to the Z-axis direction is defined as an X-axis direction; and an up-down direction on the sheet orthogonal to the Z-axis direction and the X-axis direction is defined as a Y-axis direction. In the following drawings, the arrow directions in FIG. 2 may be used, in some cases, as a standard to express a direction.

As an example, the imaging device 1 includes, in a peripheral region of the pixel section 100 (pixel array), a vertical drive circuit 111, a signal processing circuit 112, a horizontal drive circuit 113, an output circuit 114, a control circuit 115, an input/output terminal 116, and the like, as illustrated in FIG. 1. In addition, the imaging device 1 is provided with, for example, a plurality of control lines Lread and a plurality of signal lines VSL.

The control line Lread is a signal line that is able to convey a signal to control the pixel P, and is coupled to the vertical drive circuit 111 and the pixel P of the pixel section 100. In the pixel section 100, in the example illustrated in FIG. 1, the plurality of control lines Lread is wired for respective pixel rows each configured by the plurality of pixels P arranged in a horizontal direction (row direction). The control line Lread is configured to transmit a control signal to read a signal from the pixel P.

As an example, the plurality of control lines Lread for the respective pixel rows of the imaging device 1 includes wiring that transmits a signal to control a transfer transistor, wiring that transmits a signal to control a selection transistor, wiring that transmits a signal to control a reset transistor, and the like. The control line Lread may also be referred to as a drive line (pixel drive line) that transmits a signal to drive the pixel P.

The signal line VSL is a signal line that is able to convey a signal from the pixel P, and is coupled to the pixels P of the pixel section 100 and the signal processing circuit 112. In the pixel section 100, for example, one or the plurality of signal lines VSL is wired for respective pixel columns configured by the plurality of pixels P arranged in a vertical direction (column direction).

The signal line VSL is a vertical signal line, and is configured to transmit a signal outputted from the pixel P. In the imaging device 1, the plurality of signal lines VSL (e.g., three signal lines VSL1 to VSL3) may be provided for one pixel column. The imaging device 1 may include the plurality of signal lines VSL for each of the pixel columns.

The vertical drive circuit 111 is configured to be able to drive each of the pixels P of the pixel section 100. The vertical drive circuit 111 is configured by a plurality of circuits including a buffer, a shift register, an address decoder, and the like, for example. The vertical drive circuit 111 generates a signal for driving the pixel P, and outputs the generated signal to each of the pixels P of the pixel section 100 via the control line Lread. The vertical drive circuit 111 is controlled by the control circuit 115, and controls the pixel P of the pixel section 100.

The vertical drive circuit 111 generates, for example, a signal to control a selection transistor, a signal to control a reset transistor, or the like, and supplies the signal to each of the pixels P by the control line Lread. The vertical drive circuit 111 may perform a control to read a pixel signal from each of the pixels P. The vertical drive circuit 111 may also be referred to as a pixel control section configured to be able to control each of the pixels P.

The signal processing circuit 112 is configured to be able to execute signal processing of an inputted pixel signal. The signal processing circuit 112 includes, for example, a load circuit, an AD (Analog-to-Digital) conversion circuit, a horizontal selection switch, and the like. As an example, the load circuit is configured by a current source that is able to supply a current to an amplification transistor of the pixel P. The load circuit constitutes a source follower circuit together with the amplification transistor of the pixel P, for example.

The signal processing circuit 112 may include an amplification circuit configured to amplify a signal read from the pixel P via the signal line VSL. For example, the load circuit, the amplification circuit, the AD conversion circuit, and the like are provided for each of the plurality of signal lines VSL. The load circuit, the amplification circuit, the AD conversion circuit, and the like may be provided for each of the pixel columns of the pixel section 100.

The signal outputted from each of the pixels P selected and scanned by the vertical drive circuit 111 is inputted to the signal processing circuit 112 via the signal line VSL. The signal processing circuit 112 performs signal processing such as CDS (Correlated Double Sampling: correlated double sampling) and AD conversion of the signal of the pixel P.

The horizontal drive circuit 113 is configured by, for example, a buffer, a shift register, an address decoder, and the like. The horizontal drive circuit 113 is configured to be able to drive the horizontal selection switch of the signal processing circuit 112. The horizontal drive circuit 113 sequentially drives horizontal selection switches of the signal processing circuit 112 while scanning. Signals of the respective pixels P transmitted through the respective signal lines VSL are subjected to signal processing by the signal processing circuit 112, and are sequentially outputted to a horizontal signal line 121 by selective scanning by the horizontal drive circuit 113.

The output circuit 114 is configured to perform signal processing on an inputted signal to output a signal. The output circuit 114 performs signal processing on the pixel signal inputted sequentially from the signal processing circuit 112 via the horizontal signal line 121, and outputs the processed pixel signal. The output circuit 114 may perform, for example, buffering, black level adjustment, column variation correction, various types of digital signal processing, and the like.

The control circuit 115 is configured to be able to control each section of the imaging device 1. The control circuit 115 may receive a clock supplied from the outside, data ordering an operation mode, or the like, and output data such as internal information on the imaging device 1. The control circuit 115 includes, for example, a timing generator configured to be able to generate various timing signals.

The control circuit 115 controls driving of peripheral circuits such as the vertical drive circuit 111, the signal processing circuit 112, and the horizontal drive circuit 113 on the basis of the various timing signals (pulse signal, clock signal, etc.) generated by the timing generator. The input/output terminal 116 exchanges signals with the outside.

It is to be noted that the vertical drive circuit 111, the signal processing circuit 112, the horizontal drive circuit 113, the horizontal signal line 121, the output circuit 114, the control circuit 115, and the like may be provided in one semiconductor substrate, or may be provided separately in a plurality of semiconductor substrates. The imaging device 1 may have a structure (stacked structure) configured by stacking a plurality of substrates.

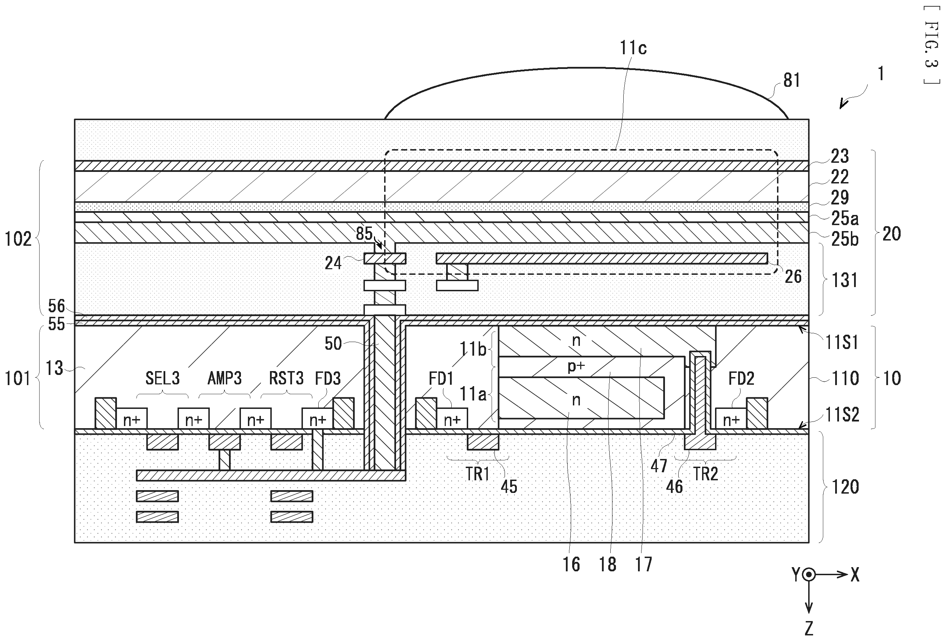

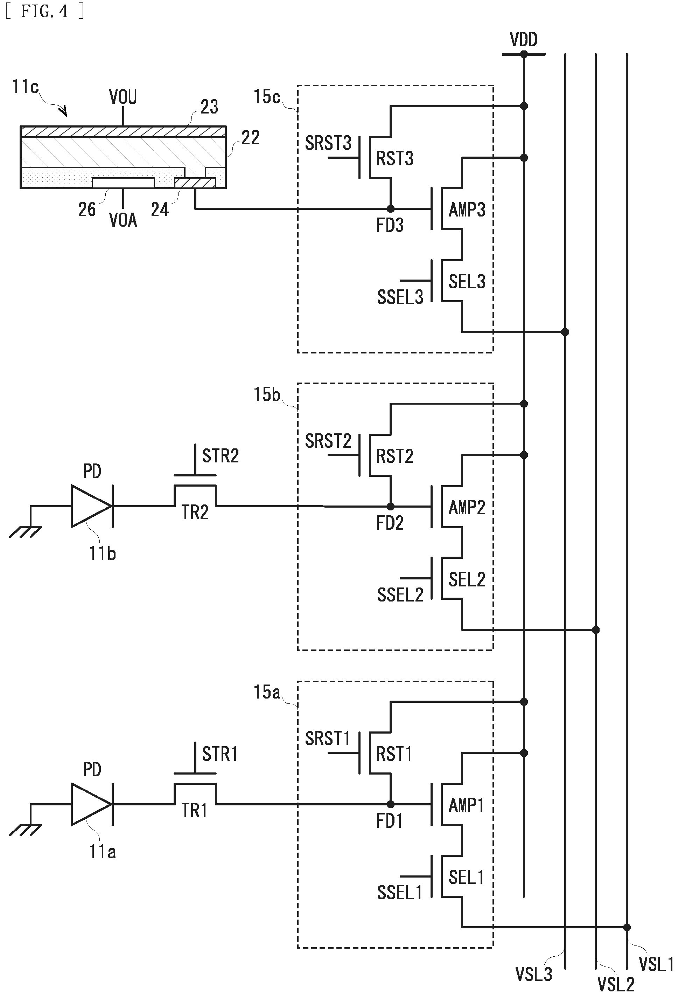

FIG. 3 is an explanatory diagram of an example of a cross-sectional configuration of the imaging device according to the first embodiment. In addition, FIG. 4 is an explanatory diagram of an example of a circuit configuration of a pixel of the imaging device according to the first embodiment. As in the example illustrated in FIG. 3, the imaging device 1 includes, for example, a light-receiving unit 10 and a light-receiving unit 20.

The light-receiving unit 10 is provided in a tier 101 of a plurality of stacked tiers. In addition, the light-receiving unit 20 is provided in a tier 102. The tier 102 including the light-receiving unit 20 is positioned above the tier 101 including the light-receiving unit 10. The imaging device 1 has a configuration in which the tier 101 including the light-receiving unit 10 and the tier 102 including the light-receiving unit 20 are stacked in the Z-axis direction.

The pixel P of the imaging device 1 includes a plurality of stacked photoelectric conversion sections (photoelectric conversion elements). The photoelectric conversion section is configured to receive light and generate a signal. In the example illustrated in FIGs. 3 and 4, the pixel P includes a photoelectric conversion section 11a, a photoelectric conversion section 11b, and a photoelectric conversion section 11c. The pixel P has a structure in which the photoelectric conversion section 11a, the photoelectric conversion section 11b, and the photoelectric conversion section 11c are stacked.

The photoelectric conversion section 11a and the photoelectric conversion section 11b are each configured by a photodiode (PD), for example. In addition, the photoelectric conversion section 11c includes a photoelectric conversion film 22. The photoelectric conversion section 11a, the photoelectric conversion section 11b, and the photoelectric conversion section 11c are each configured to be able to generate electric charge by photoelectric conversion. The imaging device 1 includes the light-receiving unit 10 that includes the photoelectric conversion sections 11a and 11b and the light-receiving unit 20 that includes the photoelectric conversion section 11c.

The light-receiving unit 10 is configured using a semiconductor layer 110. The semiconductor layer 110 has a surface 11S1 and a surface 11S2 opposed to each other, as illustrated in FIG. 3. The surface 11S2 of the semiconductor layer 110 is a surface on a side opposite to the surface 11S1. The semiconductor layer 110 is configured by a semiconductor substrate, e.g., an Si (silicon) substrate.

It is to be noted that the semiconductor layer 110 may be an SOI (Silicon On Insulator) substrate, an SiGe (silicon germanium) substrate, an SiC (silicon carbide) substrate, or the like, or may be formed using another semiconductor material. The semiconductor layer 110 may be configured by a Group III-V compound semiconductor material, or the like.

The surface 11S1 of the semiconductor layer 110 is light-receiving surface (light incident surface). The surface 11S2 of the semiconductor layer 110 is an element formation surface on which an element such as a transistor is formed. The surface 11S2 of the semiconductor layer 110 may be provided with a gate electrode, a gate insulating film (e.g., a gate oxide film), and the like.

In the example illustrated in FIG. 3, the light-receiving unit 20 is provided on a side of the surface 11S1 of the semiconductor layer 110. A wiring layer 120 is provided on a side of the surface 11S2 of the semiconductor layer 110. A lens 81, the light-receiving unit 20, and the like are provided on a side on which the light from the optical system is incident, and the wiring layer 120 is provided on a side opposite to the light incident side.

The semiconductor layer 110 is provided with a plurality of photoelectric conversion sections 11a and a plurality of photoelectric conversion sections 11b along the surface 11S1 and the surface 11S2 of the semiconductor layer 110. For example, the plurality of photoelectric conversion sections 11a and the plurality of photoelectric conversion sections 11b are formed to be embedded in the semiconductor layer 110. Each of the photoelectric conversion section 11a and the photoelectric conversion section 11b is a photodiode (PD), and converts incident light into electric charge.

The semiconductor layer 110 has a well 13, as illustrated in FIG. 3. The well 13 is, for example, a p-type semiconductor region, and is a p-type well (p-well). In the example illustrated in FIG. 3, the semiconductor layer 110 is provided with the well 13 which is a p-type well region. The well 13 is provided with a semiconductor region 16, a semiconductor region 17, and a semiconductor region 18.

Each of the semiconductor region 16 and the semiconductor region 17 is, for example, an n-type semiconductor region, and is a region formed using n-type impurities. In the example illustrated in FIG. 3, the semiconductor region 16 is provided on the side of the surface 11S2 of the semiconductor layer 110, and the semiconductor region 17 is provided on the side of the surface 11S1 of the semiconductor layer 110.

The semiconductor region 18 has, for example, an impurity concentration higher than an impurity concentration of the well 13, and serves as a p⁺ type semiconductor region. In the example illustrated in FIG. 3, a portion of the semiconductor region 18 is provided between the semiconductor region 16 and the semiconductor region 17, and another portion of the semiconductor region 18 is provided on the side of the surface 11S2 of the semiconductor layer 110. The photoelectric conversion section 11a includes the semiconductor region 16 provided in the well 13.

The photoelectric conversion section 11b includes the semiconductor region 17 provided in the well 13. The photoelectric conversion section 11b is formed to be stacked on the photoelectric conversion section 11a in the semiconductor layer 110. The photoelectric conversion section 11b is provided closer to the light incident side than the photoelectric conversion section 11a. Each of the photoelectric conversion section 11a and the photoelectric conversion section 11b performs photoelectric conversion to generate electric charge corresponding to a received light amount. Each of the photoelectric conversion sections 11a and 11b of each of the pixels P may also be referred to as a photoelectric conversion region.

The photoelectric conversion section 11a and the photoelectric conversion section 11b may be configured to photoelectrically convert light beams of wavelength regions different from each other. The photoelectric conversion section 11a and the photoelectric conversion section 11b selectively receive and photoelectrically convert light beams of specific wavelength regions, for example, in accordance with positions where the photoelectric conversion sections 11a and 11b are provided in the semiconductor layer 110, constituent materials thereof, or the like.

The photoelectric conversion section 11a and the photoelectric conversion section 11b are positioned at different distances (depths) from the surface 11S1 of the semiconductor layer 110, and absorb light beams of wavelengths of different colors in accordance with the light incident depth (penetration depth) to generate electric charge. In the example illustrated in FIG. 3, the photoelectric conversion section 11a may be disposed below the photoelectric conversion section 11b, and photoelectrically convert light transmitted through the photoelectric conversion section 11b to generate electric charge.

In addition, the semiconductor layer 110 is provided with a plurality of floating diffusions (floating diffusions FD1, FD2, and FD3 in the example illustrated in FIGs. 3 and 4) for each of the pixels P or for every plurality of pixels P. The floating diffusions FD1 to FD3 each include, for example, an n-type semiconductor region.

The wiring layer 120 includes, for example, a conductive film and an insulating film, and includes a plurality of wirings, vias (VIA), and the like. The wiring layer 120 is a multilayer wiring layer, and includes wiring of two or more layers or a three or more layers, for example. The wiring layer 120 has a configuration in which a plurality of wirings is stacked, with an insulating film as an interlayer insulating film (interlayer insulating layer) being interposed therebetween.

The wiring of the wiring layer 120 is formed using a metal material such as aluminum (Al), tungsten (W), or copper (Cu), for example. The wiring of the wiring layer 120 may be configured using polysilicon (Poly-Si), or another electrically-conductive material. The interlayer insulating film is formed using silicon oxide (SiO), silicon nitride (SiN), silicon oxynitride (SiON), or the like, for example.

In the semiconductor layer 110 and the wiring layer 120, for example, a plurality of readout circuits 15 (readout circuits 15a, 15b, and 15c in the example illustrated in FIG. 4) is provided for each of the pixels P or for every plurality of pixels P. It is to be noted that the vertical drive circuit 111, the signal processing circuit 112, the horizontal drive circuit 113, the horizontal signal line 121, the output circuit 114, the control circuit 115, and the like, which are described above, may be provided in a substrate different from the semiconductor layer 110, or in the semiconductor layer 110 and the wiring layer 120.

The lens 81 is a lens that condenses light, and is an optical member also referred to as an on-chip lens. The lens 81 is configured by, for example, silicon oxide, silicon nitride, silicon oxynitride, or the like. It is to be noted that the lens 81 may be formed using another material that transmits light.

The lens 81 (lens section) is provided above the semiconductor layer 110, for example, for each of the pixels P or for every plurality of pixels P. The lens 81 receives incident light from a subject which is a measurement target via an optical system such as an imaging lens. The lens 81 guides incident light to a side of the semiconductor layer 110.

In the imaging device 1, the photoelectric conversion section 11a, the photoelectric conversion section 11b, and the photoelectric conversion section 11c each photoelectrically convert the light incident via the lens 81. Each of the photoelectric conversion section 11a, the photoelectric conversion section 11b, and the photoelectric conversion section 11c may absorb the incident light to generate electric charge.

A transistor TR1, a transistor TR2, the floating diffusions FD1 to FD3, and the like are provided on the side of the surface 11S2 of the semiconductor layer 110. The transistor TR1 includes a gate electrode 45, and is provided for the photoelectric conversion section 11a. The transistor TR1 is a transfer transistor, and is configured to be able to transfer electric charge photoelectrically converted by the photoelectric conversion section 11a to the floating diffusion FD1.

The transistor TR2 includes a gate electrode 46 and a gate insulating film 47, and is provided for the photoelectric conversion section 11b. The transistor TR2 is a transfer transistor, and is configured to be able to transfer electric charge photoelectrically converted by the photoelectric conversion section 11b to the floating diffusion FD2. For example, the transistor TR2 has a vertical gate structure. At least a portion of each of the gate electrode 46 and the gate insulating film 47 is provided in the semiconductor layer 110.

As in the example illustrated in FIG. 3, for example, at least a portion of each of the gate electrode 46 and the gate insulating film 47 is provided to be dug into the semiconductor layer 110. The transistor TR2 may also be referred to as a vertical transistor. A portion of each of the gate electrode 46 and the gate insulating film 47 may be disposed to be embedded in the semiconductor layer 110.

The gate electrode 46 of the transistor TR2 is provided to extend in a thickness direction of the semiconductor layer 110, for example. As an example, the gate electrode 46 and the gate insulating film 47 of the transistor TR2 are formed to reach the photoelectric conversion section 11b in the semiconductor layer 110. In the example illustrated in FIG. 3, a portion of the gate electrode 46 of the transistor TR2 extends from the surface 11S2 of the semiconductor layer 110 toward the inside of the semiconductor layer 110, and is provided up to a region of the photoelectric conversion section 11b.

The gate electrode 45 of the transistor TR1 and the gate electrode 46 of the transistor TR2 are each configured using polysilicon (Poly-Si), for example. The gate electrode 45 and the gate electrode 46 may be configured using a metal material or a metal compound. The gate electrode 45 and the gate electrode 46 may each be configured by titanium nitride (TiN), tantalum nitride (TaN), tungsten (W), or the like, for example.

The gate insulating film 47 is configured by, for example, a monolayer film including one of silicon oxide (SiO), silicon oxynitride (SiON), hafnium oxide (HfO), or the like, or a stacked film including two or more thereof. The gate insulating film 47 may be formed using a high-permittivity material having a permittivity higher than a permittivity of silicon oxide, such as a hafnium-based insulating film.

The light-receiving unit 20 of the imaging device 1 includes a plurality of photoelectric conversion sections 11c. The photoelectric conversion section 11c of each of the pixels P includes the photoelectric conversion film 22, an upper electrode 23, and a readout electrode 24, as in the example illustrated in FIG. 3. In addition, the photoelectric conversion section 11c includes a semiconductor layer 25a, a semiconductor layer 25b, and an accumulation electrode 26. Further, the light-receiving unit 20 of the imaging device 1 may include a protective layer 29, as in the example illustrated in FIG. 3.

The photoelectric conversion film 22 generates electric charge by photoelectric conversion. The photoelectric conversion film 22 may photoelectrically convert incident light to generate electric charge corresponding to a received light amount. The photoelectric conversion film 22 may also be referred to as a photoelectric conversion layer. The photoelectric conversion film 22 (photoelectric conversion layer) is, for example, a photoelectric conversion film including an organic material.

In the imaging device 1, for example, each of the pixels P is provided with the photoelectric conversion film 22 formed by an organic semiconductor material. A photoelectric conversion film configured using an inorganic material may be disposed as the photoelectric conversion film 22. The material of the photoelectric conversion film 22 may be selected in accordance with, for example, a wavelength region of incident light as a measurement target.

The upper electrode 23 is, for example, an electrode common to the photoelectric conversion films 22 of the plurality of pixels P, and is provided on a side of one surface of the photoelectric conversion film 22. In each of the pixels P, the readout electrode 24 and the accumulation electrode 26 are provided for the photoelectric conversion film 22. The readout electrode 24 and the accumulation electrode 26 are provided, for each of the pixels P or for every plurality of pixels P, on a side of the other surface of the photoelectric conversion film 22. The readout electrode 24 and the accumulation electrode 26 are each an electrode for use in controlling electric charge photoelectrically converted by the photoelectric conversion film 22.

In the example illustrated in FIG. 3, the upper electrode 23 and the readout electrode 24 are disposed to sandwich the photoelectric conversion film 22, the protective layer 29, and the semiconductor layers 25a and 25b. The readout electrode 24 is provided to be opposed to the upper electrode 23 to sandwich a portion of each of the semiconductor layers 25a and 25b, the protective layer 29, and the photoelectric conversion film 22. The upper electrode 23 is an upper electrode of the photoelectric conversion film 22, and the readout electrode 24 is a lower electrode of the photoelectric conversion film 22.

The upper electrode 23 is an electrode common to the plurality of pixels P, and may also be referred to as a common electrode. The readout electrode 24 may also be referred to as a lower electrode. The upper electrode 23, the readout electrode 24, the accumulation electrode 26, and the like are electrically coupled to the circuits provided in the semiconductor layer 110 and the wiring layer 120, for example, via wirings, electrodes, and the like different from one another.

The readout electrode 24 and the accumulation electrode 26 are provided in an insulating layer 131. The insulating layer 131 is provided on the surface 11S1 of the semiconductor layer 110. The insulating layer 131 is formed using an insulating film such as an oxide film, a nitride film, or an oxynitride film, for example. The insulating layer 131 may be configured by silicon oxide (SiO), silicon nitride (SiN), silicon oxynitride (SiON), or the like, or may be configured by another material that transmits light as a measurement target.

The protective layer 29 is a protective layer including an inorganic material, for example, and is provided between the photoelectric conversion film 22 and the semiconductor layer 25a. In the example illustrated in FIG. 3, the protective layer 29 is formed between the photoelectric conversion film 22 and the semiconductor layer 25a, and is positioned on the semiconductor layer 25a. The protective layer 29 may also be referred to as a passivation film (protective film).

The protective layer 29 is, for example, a layer containing at least one of Ti (titanium), Si (silicon), Zr (zirconium), Nb (niobium), V (vanadium), Ta (tantalum), Hf (hafnium), Al (aluminum), Sn (tin), Sc (scandium), Y (yttrium), La (lanthanide), Ga (gallium), or Mg (magnesium).

The semiconductor layer 25a and the semiconductor layer 25b are provided between the photoelectric conversion film 22 and the insulating layer 131 in which the readout electrode 24, the accumulation electrode 26, and the like are provided. In the example illustrated in FIG. 3, the semiconductor layer 25a and the semiconductor layer 25b are positioned between the insulating layer 131 and the protective layer 29. The semiconductor layer 25a and the semiconductor layer 25b are each a layer for use in accumulating and transferring electric charge photoelectrically converted by the photoelectric conversion film 22, and may each also be referred to as a charge accumulation transfer layer. The semiconductor layer 25a and the semiconductor layer 25b are disposed to be opposed to the photoelectric conversion film 22.

The semiconductor layer 25a and the semiconductor layer 25b are each, for example, a semiconductor layer including an oxide semiconductor. The semiconductor layer 25a is provided, for example, between the photoelectric conversion film 22 and the semiconductor layer 25b. In the example illustrated in FIG. 3, the semiconductor layer 25a is positioned between the protective layer 29 and the semiconductor layer 25b, and is formed on the semiconductor layer 25b. As an example, the semiconductor layer 25a is provided in contact with the protective layer 29.

The semiconductor layer 25b is formed between the semiconductor layer 25a and the insulating layer 131 in which the readout electrode 24, the accumulation electrode 26, and the like are provided. As in the example illustrated in FIG. 3, the semiconductor layer 25b is provided between the semiconductor layer 25a and the accumulation electrode 26 and between the semiconductor layer 25a and the readout electrode 24. The semiconductor layer 25b may be provided in contact with the semiconductor layer 25a.

The semiconductor layer 25a may be configured to have a high carrier concentration (carrier density). The semiconductor layer 25a is configured to have a carrier concentration higher (larger) than a carrier concentration of the semiconductor layer 25b, for example. When the carrier concentration in the semiconductor layer 25a is defined as N1 and the carrier concentration in the semiconductor layer 25b is defined as N2, the semiconductor layer 25a and the semiconductor layer 25b may be formed to satisfy N1 > N2.

For example, the carrier concentration N1 (carrier density) of the semiconductor layer 25a may be 1 × 10¹⁸ cm⁻³ or more. In addition, the carrier concentration N2 of the semiconductor layer 25b may be less than 1 × 10¹⁸ cm⁻³. In the imaging device 1, the semiconductor layer 25a may have a relatively high carrier concentration. The semiconductor layer 25a may have a thickness (film thickness) of 10 nm or less, for example.

In addition, the imaging device 1 may be configured to allow a difference between a Fermi level and an energy level at a conduction band lower end in the semiconductor layer 25a to be relatively small. For example, a difference φ1 between the Fermi level and the energy level at the conduction band lower end in the semiconductor layer 25a is smaller than a difference φ2 between a Fermi level and an energy level at a conduction band lower end in the semiconductor layer 25b.

In the imaging device 1, the semiconductor layer 25a and the semiconductor layer 25b may be provided to satisfy φ1 < φ2. For example, the semiconductor layer 25a and the semiconductor layer 25b may be formed to satisfy φ2 - φ1 > 0.02 eV. The semiconductor layer 25a and the semiconductor layer 25b may be configured to allow the difference φ2 between the Fermi level and the energy level at the conduction band lower end of the semiconductor layer 25b to be larger, by 0.02 eV or more, than the difference φ1 between the Fermi level and the energy level at the conduction band lower end of the semiconductor layer 25a.

A difference between a vacuum level and the energy level at the conduction band lower end in the semiconductor layer 25a may be larger than a difference between a vacuum level and the energy level at the conduction band lower end in the semiconductor layer 25b. In the photoelectric conversion section 11c of the imaging device 1, the semiconductor layer 25a and the semiconductor layer 25b may be provided in contact with each other with band bending.

The semiconductor layer 25a and the semiconductor layer 25b are formed using an oxide semiconductor material, for example. The semiconductor layer 25a and the semiconductor layer 25b are each, for example, an oxide semiconductor layer containing at least one of In (indium), Ga (gallium), Zn (zinc), Ti (titanium), Sn (tin), Si (silicon), Cu (copper), Sb (antimony), or Cd (cadmium).

As an example, the semiconductor layer 25a and the semiconductor layer 25b are each configured using IGZO (indium-gallium-zinc oxide). The semiconductor layer 25a and the semiconductor layer 25b may be configured using the same type of materials, or may be configured using different materials. It is to be noted that each of the semiconductor layers 25a and 25b may be configured by stacking a plurality of films. The material of the semiconductor layer 25a may be selected, for example, depending on the material of the photoelectric conversion film 22, the material of the semiconductor layer 25b, electron affinity, work function, carriers (signal charge), and the like.

The semiconductor layer 25a and the semiconductor layer 25b may each be an oxide semiconductor layer containing In (indium), as described above. The In composition ratio in the semiconductor layer 25a may be larger than the In composition ratio in the semiconductor layer 25b. Making the In composition ratio in the semiconductor layer 25a larger (higher) enables the carrier concentration N1 of the semiconductor layer 25a to be larger.

It is to be noted that the carrier concentration may be measured, for example, by means of a spreading resistance measurement method, a scanning capacitance microscopy, or the like. In addition, XPS (X-ray photoelectron spectroscopy), UPS (ultraviolet photoelectron spectroscopy), a Kelvin probe method, and the like may be used to measure and analyze an energy level, a work function, and the like.

The readout electrode 24 is electrically coupled to the semiconductor layers 25a and 25b. For example, the readout electrode 24 is provided to be in contact with the semiconductor layer 25b. In the example illustrated in FIG. 3, the readout electrode 24 is in contact with the semiconductor layer 25b in an opening 85 (hole) provided in the insulating layer 131. The readout electrode 24 is an electrode for use in reading electric charge converted by the photoelectric conversion film 22.

The accumulation electrode 26 is positioned below the semiconductor layer 25b with a portion of the insulating layer 131 interposed therebetween. In the example illustrated in FIG. 3, the accumulation electrode 26 is disposed to be opposed to the upper electrode 23, with a portion of the insulating layer 131, the semiconductor layers 25a and 25b, the protective layer 29, and the photoelectric conversion film 22 being interposed therebetween. The accumulation electrode 26 is an electrode for use in controlling the accumulation of electric charge converted by the photoelectric conversion film 22.

It is possible, in the imaging device 1, to attract electric charge photoelectrically converted by the photoelectric conversion film 22 to a side of the semiconductor layer 25a and the semiconductor layer 25b, depending on a potential of the accumulation electrode 26 of each of the pixels P. For example, the vertical drive circuit 111 (see FIG. 1) of the imaging device 1 may control voltages (a voltage VOU and a voltage VOA in FIG. 4) to be supplied to the upper electrode 23 and the accumulation electrode 26 to thereby allow signal charge (e.g., electrons) generated by the photoelectric conversion film 22 to be accumulated in a region part, of the semiconductor layer 25b, opposed to the accumulation electrode 26.

In addition, changing the voltage (voltage VOA in FIG. 4) to be applied to the accumulation electrode 26 enables electric charge accumulated by the semiconductor layer 25a and the semiconductor layer 25b to be moved to a side of the readout electrode 24. For example, the vertical drive circuit 111 may adjust the voltage VOA to be inputted to the accumulation electrode 26 and transmit electric charge, which has been photoelectrically converted and accumulated, to the readout electrode 24.

The upper electrode 23, the readout electrode 24, and the accumulation electrode 26, which are described above, are each a transparent electrode, for example, and may be configured by ITO (indium tin oxide), IZO (indium zinc oxide), tin oxide (SnO), zinc oxide (ZnO), or the like. The upper electrode 23, the readout electrode 24, and the accumulation electrode 26 may be configured by another metal oxide, or may be configured using another transparent electrically-conductive material.

The upper electrode 23, the readout electrode 24, and the accumulation electrode 26 may be formed using a tin oxide-based material such as tin oxide (ATO) doped with antimony (Sb) (added thereto), or tin oxide (FTO) doped with fluorine (F). The upper electrode 23, the readout electrode 24, and the accumulation electrode 26 may be formed using a zinc oxide-based material.

The upper electrode 23, the readout electrode 24, and the accumulation electrode 26 may be configured by, for example, aluminum zinc oxide (AZO), gallium zinc oxide (GZO), indium zinc oxide (IZO), indium gallium zinc oxide (IGZO), or the like. In addition, the upper electrode 23, the readout electrode 24, and the accumulation electrode 26 may be formed using CuI, InSbO₄, ZnMgO, CuInO₂, MgIN₂O₄, CdO, ZnSnO₃, TiO₂, a spinel type oxide, an oxide having a YbFe₂O₄ structure, or the like.

In a case where transparency is not required, the upper electrode 23, the readout electrode 24, or the accumulation electrode 26 may be configured by, for example, an alkali metal (lithium (Li), sodium (Na), potassium (K), etc.), an alkaline earth metal (magnesium (Mg), calcium (Ca), etc.), or the like. In addition, the upper electrode 23, the readout electrode 24, or the accumulation electrode 26 may be formed using a metal material such as platinum (Pt), gold (Au), palladium (Pd), chromium (Cr), nickel (Ni), aluminum (Al), silver (Ag), tantalum (Ta), tungsten (W), copper (Cu), titanium (Ti), indium (In), tin (Sn), iron (Fe), cobalt (Co), or molybdenum (Mo).

The electrodes provided for the photoelectric conversion section 11c, such as the upper electrode 23, the readout electrode 24, and the accumulation electrode 26 may be configured using an electrically-conductive material such as polysilicon containing impurities, a carbon-based material, an oxide semiconductor, a carbon nanotube, or graphene. In addition, the upper electrode 23, the readout electrode 24, the accumulation electrode 26, or the like may be formed using an organic material (electrically-conductive polymer) such as poly(3,4-ethylenedioxythiophene)/polystyrene sulfonate [PEDOT/PSS].

The photoelectric conversion film 22 may absorb, for example, 60% or more of light of a predetermined wavelength included at least in a visible light region to a near-infrared region to perform charge separation. The photoelectric conversion film 22 absorbs light beams of some or all of wavelengths of the visible light region and the near infrared light region of 400 nm or more and less than 1300 nm, for example. The photoelectric conversion film 22 includes, for example, two or more organic materials that function as a p-type semiconductor or an n-type semiconductor, and has a junction surface (p/n junction surface) between the p-type semiconductor and the n-type semiconductor. Other than those mentioned above, the photoelectric conversion film 22 may have a stacked structure (p-type semiconductor layer/n-type semiconductor layer) of a layer including the p-type semiconductor layer (p-type semiconductor layer) and a layer including the n-type semiconductor layer (n-type semiconductor layer). Alternatively, the photoelectric conversion film 22 may have a stacked structure (p-type semiconductor layer/ bulk hetero layer) of the p-type semiconductor layer and a mixed layer (bulk hetero layer) of the p-type semiconductor and the n-type semiconductor, or may have a stacked structure (n-type semiconductor layer/ bulk hetero layer) of the n-type semiconductor layer and the bulk hetero layer. In addition, the photoelectric conversion film 22 may be formed only by the mixed layer (bulk hetero layer) of the p-type semiconductor and the n-type semiconductor.

For example, the p-type semiconductor is a hole-transporting material that relatively functions as an electron donor, and the n-type semiconductor is an electron-transporting material that relatively functions as an electron acceptor. For example, the photoelectric conversion film 22 provides a field where excitons (electron-hole pairs) generated in absorbing light are separated into electrons and holes. Specifically, the electron-hole pairs are separated into electrons and holes at an interface (p/n junction surface) between the electron donor and the electron acceptor.

Examples of the p-type semiconductor include thienoacene-based materials typified by a naphthalene derivative, an anthracene derivative, a phenanthrene derivative, a pyrene derivative, a perylene derivative, a tetracene derivative, a pentacene derivative, a quinacridone derivative, a thiophene derivative, a thienothiophene derivative, a benzothiophene derivative, a benzothienobenzothiophene (BTBT) derivative, a dinaphthothienothiophene (DNTT) derivative, a dianthracenothienothiophene (DATT) derivative, a benzobisbenzothiophene (BBBT) derivative, a thienobisbenzothiophene (TBBT) derivative, a dibenzothienobisbenzothiophene (DBTBT) derivative, a dithienobenzodithiophene (DTBDT) derivative, a dibenzothienodithiophene (DBTDT) derivative, a benzodithiophene (BDT) derivative, a naphthodithiophene (NDT) derivative, an anthracenodithiophene (ADT) derivative, a tetracenodithiophene (TDT) derivative, and a pentacenodithiophene (PDT) derivative. Other examples of the p-type semiconductor include a triphenylamine derivative, a carbazole derivative, a picene derivative, a chrysene derivative, for example, a fluoranthene derivative, a phthalocyanine derivative, a subphthalocyanine derivative, a subporphyrazine derivative, a metal complex including a heterocyclic compound as a ligand, a polythiophene derivative, a polybenzothiadiazole derivative, a polyfluorene derivative, and the like.

Examples of the n-type semiconductor include a fullerene and a derivative thereof typified by higher fullerene, such as fullerene C₆₀, fullerene C₇₀, and fullerene C₇₄, endohedral fullerene, and the like. Examples of a substituent included in the fullerene derivative include a halogen atom, a straight-chain, branched, or cyclic alkyl group or phenyl group, a group including a straight-chain or condensed aromatic compound, a group including a halide, a partial fluoroalkyl group, a perfluoroalkyl group, a silyl alkyl group, a silyl alkoxy group, an aryl silyl group, an aryl sulfanyl group, an alkyl sulfanyl group, an aryl sulfonyl group, an alkyl sulfonyl group, an aryl sulfide group, an alkyl sulfide group, an amino group, an alkyl amino group, an aryl amino group, a hydroxy group, an alkoxy group, an acyl amino group, an acyloxy group, a carbonyl group, a carboxy group, a carboxamide group, a carboalkoxy group, an acyl group, a sulfonyl group, a cyano group, a nitro group, a group including a chalcogenide, a phosphine group, a phosphone group, and derivatives thereof. Specific examples of the fullerene derivative include fullerene fluoride, a PCBM fullerene compound, a fullerene multimer, and the like. Other examples of the n-type semiconductor include an organic semiconductor having a HOMO level and a LUMO level larger than those of the p-type semiconductor, and an inorganic metal oxide having light transmissivity.

Examples of the n-type organic semiconductor include a heterocyclic compound containing a nitrogen atom, an oxygen atom, or a sulfur atom. Specific examples thereof include organic molecules including, as a portion of a molecular skeleton, a pyridine derivative, a pyrazine derivative, a pyrimidine derivative, a triazine derivative, a quinoline derivative, a quinoxaline derivative, an isoquinoline derivative, an acridine derivative, a phenazine derivative, a phenanthroline derivative, a tetrazole derivative, a pyrazole derivative, an imidazole derivative, a thiazole derivative, an oxazole derivative, an imidazole derivative, a benzimidazol derivative, a benzotriazole derivative, a benzoxazole derivative, a carbazole derivative, a benzofuran derivative, a dibenzofuran derivative, a subporphyrazine derivative, a polyphenylene vinylene derivative, a polybenzothiadiazole derivative, a polyfluorene derivative, and the like, an organic metal complex, a subphthalocyanine derivative, a quinacridone derivative, a cyanine derivative, and a merocyanine derivative.

In addition to the p-type semiconductor and the n-type semiconductor, the photoelectric conversion film 22 may further include an organic material, i.e., a so-called coloring material that absorbs light of a predetermined wavelength region while transmitting light of another wavelength region. In a case where the photoelectric conversion film 22 is formed using three types of organic materials of the p-type semiconductor, the n-type semiconductor, and the coloring material, the p-type semiconductor and the n-type semiconductor may each be a material having light transmissivity in a visible light region. Thus, in the photoelectric conversion film 22, light of a wavelength region, to be absorbed by the coloring material, is photoelectrically converted selectively.

As illustrated in FIG. 3, the imaging device 1 includes a through-electrode 50. The through-electrode 50 is a coupling electrode (coupling section), and couples circuits (elements) provided in different layers to each other. As an example, the through-electrode 50 is provided in the tier 101 to penetrate the semiconductor layer 110. The through-electrode 50 is a structure provided in the semiconductor layer 110 to penetrate the semiconductor layer 110.

In the imaging device 1, the through-electrode 50 is provided for each of the pixels P or for every plurality of pixels P. For example, the through-electrode 50 is formed to reach the surface 11S2 of the semiconductor layer 110 from below the photoelectric conversion section 11c. In the example illustrated in FIG. 3, the through-electrode 50 is formed to extend in the Z-axis direction to reach the inside of the wiring layer 120.

In the imaging device 1, the through-electrode 50 electrically couples the readout electrode 24 of the photoelectric conversion section 11c and the circuit provided on the side of the surface 11S2 of the semiconductor layer 110 to each other. The readout electrode 24 of the photoelectric conversion section 11c is electrically coupled to the readout circuit 15c (see FIG. 4) via the through-electrode 50.

Electric charge photoelectrically converted and accumulated in the photoelectric conversion section 11c is transferred by the readout electrode 24 to the floating diffusion FD3 of the readout circuit 15c via the through-electrode 50. The floating diffusion FD3 accumulates the transferred electric charge.

The through-electrode 50 is configured by, for example, tungsten (W), aluminum (Al), copper (Cu), silver (Ag), or the like. The through-electrode 50 may be formed using each of cobalt (Co), molybdenum (Mo), ruthenium (Ru), and the like. The through-electrode 50 may be configured by another metal material.

The imaging device 1 may include at least one of a fixed charge film 55 or a reflection suppression film 56 on the side of the surface 11S1 of the semiconductor layer 110. A portion of each of the fixed charge film 55 and the reflection suppression film 56 is provided along a side surface of the through-electrode 50, for example, as in the example illustrated in FIG. 3. As an example, the fixed charge film 55 and the reflection suppression film 56 are each configured by a metal compound (a metal oxide, a metal nitride, etc.).

The fixed charge film 55 is a film having a fixed electric charge, and may be formed using a high-dielectric material. As an example, the fixed charge film 55 is configured by a metal oxide such as hafnium oxide, aluminum oxide, tantalum oxide, titanium oxide, or zirconium oxide. The fixed charge film 55 is, for example, a film having negative fixed electric charge.

In the imaging device 1, providing the fixed charge film 55 suppresses generation of a dark current at an interface of the semiconductor layer 110. It is to be noted that the fixed charge film 55 may be configured by another metal oxide film, or may be configured using a metal nitride film or a metal oxynitride film. A film having positive fixed electric charge may be provided as the fixed charge film 55.

As an example, the reflection suppression film 56 is configured by a metal oxide such as hafnium oxide or tantalum oxide. The reflection suppression film 56 is provided on the side of the surface 11S1 of the semiconductor layer 110, and reduces (suppresses) reflection. The reflection suppression film 56 (antireflection film) is provided to be stacked on the fixed charge film 55, for example. It is to be noted that the reflection suppression film 56 may be configured using an insulating material such as silicon nitride (SiN), silicon oxide (SiO), silicon oxynitride (SiON), TEOS, or aluminum oxide (AlO), or may be configured using another material.

The imaging device 1 is provided with a readout circuit configured to be able to output a signal based on electric charge converted by the photoelectric conversion section 11a, a signal based on electric charge converted by the photoelectric conversion section 11b, and a signal based on electric charge converted by the photoelectric conversion section 11c. The imaging device 1 includes the plurality of readout circuits 15 each including, for example, an amplification transistor, a selection transistor, a reset transistor, and the like.

As an example, the plurality of readout circuits 15 (the readout circuit 15a, the readout circuit 15b, and the readout circuit 15c in FIG. 4) is provided for each of the pixels P or for every plurality of pixels P. It is to be noted that the imaging device 1 may have a configuration in which the plurality of pixels P shares the readout circuits 15.

As illustrated in FIG. 4, the pixel P of the imaging device 1 includes the above-described photoelectric conversion section 11a, the transfer transistor TR1, and the readout circuit 15a. In addition, the pixel P includes the photoelectric conversion section 11b, the transfer transistor TR2, the readout circuit 15b, the photoelectric conversion section 11c, and the readout circuit 15c. The readout circuits 15a, 15b, and 15c are each configured to be able to output a signal based on photoelectrically converted electric charge.

As an example, the readout circuit 15a includes the floating diffusion FD1, an amplification transistor AMP1, a selection transistor SEL1, and a reset transistor RST1. The readout circuit 15a is configured to be able to read a signal (a first pixel signal) based on electric charge accumulated in the floating diffusion FD1 to the signal line VSL1. It is to be noted that the readout circuit 15a may include the transfer transistor TR1.

The transfer transistor TR1, the amplification transistor AMP1, the selection transistor SEL1, and the reset transistor RST1 are each a MOS transistor (MOSFET) including terminals of a gate, a source, and a drain. In the example illustrated in FIG. 4, the transfer transistor TR1, the amplification transistor AMP1, the selection transistor SEL1, and the reset transistor RST1 are each configured by an NMOS transistor. It is to be noted that the transistor of the pixel P may be configured by a PMOS transistor.

The transfer transistor TR1 is configured to be able to transfer electric charge photoelectrically converted by the photoelectric conversion section 11a. The transfer transistor TR1 is controlled by a signal STR1 to electrically couple or decouple the photoelectric conversion section 11a and the floating diffusion FD1 to or from each other. The transfer transistor TR1 may transfer electric charge photoelectrically converted and accumulated in the photoelectric conversion section 11a to the floating diffusion FD1.

The floating diffusion FD1 is an accumulation section, and is configured to be able to accumulate transferred electric charge. The floating diffusion FD1 may accumulate electric charge photoelectrically converted by the photoelectric conversion section 11a. The floating diffusion FD1 may also be referred to as a holding section that is able to hold the transferred electric charge. The floating diffusion FD1 accumulates the transferred electric charge, and converts the accumulated electric charge into a voltage corresponding to a capacitance of the floating diffusion FD1.

The amplification transistor AMP1 is configured to generate and output a signal based on the electric charge accumulated in the floating diffusion FD1. As illustrated in FIG. 4, the gate of the amplification transistor AMP1 is electrically coupled to the floating diffusion FD1, and receives an input of the voltage converted by the floating diffusion FD1.

The drain of the amplification transistor AMP1 is coupled to a power supply line to which a power supply voltage VDD is supplied. The source of the amplification transistor AMP1 is coupled to the signal line VSL1 via the selection transistor SEL1. The amplification transistor AMP1 may generate a signal based on the electric charge accumulated in the floating diffusion FD1, i.e., a signal based on the voltage of the floating diffusion FD1, and may output the generated signal to the signal line VSL1.

The selection transistor SEL1 is configured to be able to control the output of a pixel signal. The selection transistor SEL1 is electrically coupled in series to the amplification transistor AMP1, for example, as in the example illustrated in FIG. 4. The selection transistor SEL1 is controlled by a signal SSEL1, and is configured to be able to output a signal from the amplification transistor AMP1 to the signal line VSL1. The selection transistor SEL1 may control an output timing of the pixel signal.

The selection transistor SEL1 is configured to be able to output a signal (first pixel signal) based on the electric charge converted by the photoelectric conversion section 11a. The selection transistor SEL1 may output the first pixel signal of the pixel P to the signal line VSL1. It is to be noted that the selection transistor SEL1 may be electrically coupled between the amplification transistor AMP1 and the power supply line to which the power supply voltage VDD is applied. In addition, the selection transistor SEL1 may be omitted as needed.

The reset transistor RST1 is configured to be able to reset the voltage of the floating diffusion FD1. In the example illustrated in FIG. 4, the reset transistor RST1 is electrically coupled to the power supply line, to which the power supply voltage VDD is applied, and is configured to reset electric charge. The reset transistor RST1 may be controlled by a signal SRST1 to reset the electric charge accumulated in the floating diffusion FD1 and to reset the voltage of the floating diffusion FD1.

The reset transistor RST1 may electrically couple the power supply line and the floating diffusion FD1 to each other to discharge the electric charge accumulated in the floating diffusion FD1. It is to be noted that the reset transistor RST1 may discharge the electric charge accumulated in the photoelectric conversion section 11a via the transfer transistor TR1.

The vertical drive circuit 111 (see FIG. 1) of the imaging device 1 supplies a control signal to the gates of the transfer transistor TR1, the selection transistor SEL1, the reset transistor RST1, and the like of each of the pixels P via the control line Lread described above, to bring each of the transistors into an ON state (an electrically-conductive state) or an OFF state (a non-electrically-conductive state).

As an example, the plurality of control lines Lread for respective pixel rows of the imaging device 1 includes wiring that transmits the signal STR1 to control the transfer transistor TR1, wiring that transmits the signal SSEL1 to control the selection transistor SEL1, wiring that transmits the signal SRST1 to control the reset transistor RST1, and the like.

The transfer transistor TR1, the selection transistor SEL1, the reset transistor RST1, and the like are controlled to be ON/OFF by the vertical drive circuit 111. The vertical drive circuit 111 controls the readout circuit 15a of each of the pixels P to thereby output the first pixel signal based on the electric charge generated by the photoelectric conversion section 11a from each of the pixels P to the signal line VSL1. The vertical drive circuit 111 may perform a control to read the first pixel signal of each of the pixels P to the signal line VSL1.

The readout circuit 15a may be configured to be able to change conversion efficiency (gain) in converting electric charge into a voltage. For example, the readout circuit 15a may include a switching transistor for use in setting the conversion efficiency. As an example, the switching transistor is provided between the floating diffusion FD1 and the reset transistor RST1.

It is to be noted that the switching transistor may be electrically coupled in series to the reset transistor RST1, or may be electrically coupled in parallel to the reset transistor RST1. For example, the switching transistor may be configured to be able to electrically couple the floating diffusion FD1 and a capacitor to each other.

In the readout circuit 15a, the switching transistor being brought into an ON state increases a capacitance to be added to the floating diffusion FD1 of the pixel P, thus switching the conversion efficiency. The switching transistor may switch a capacitance to be coupled to the gate of the amplification transistor AMP1 to change the conversion efficiency.

For example, the readout circuit 15b has a circuit configuration similar to that of the readout circuit 15a. The floating diffusion FD2 of the readout circuit 15b corresponds to the floating diffusion FD1 of the readout circuit 15a. The transfer transistor TR2 may transfer the electric charge photoelectrically converted by the photoelectric conversion section 11b to the floating diffusion FD2. The floating diffusion FD2 may accumulate the electric charge photoelectrically converted by the photoelectric conversion section 11b. It is to be noted that the readout circuit 15b may include the transfer transistor TR2.

An amplification transistor AMP2 in the readout circuit 15b corresponds to the amplification transistor AMP1 of the readout circuit 15a. A selection transistor SEL2 corresponds to the selection transistor SEL1. A reset transistor RST2 corresponds to the reset transistor RST1. The readout circuit 15b may generate and output a signal based on the electric charge accumulated in the floating diffusion FD2, i.e., a signal (a second pixel signal) based on the electric charge converted by the photoelectric conversion section 11b.

The transfer transistor TR2, the selection transistor SEL2, the reset transistor RST2, and the like are controlled to be ON/OFF by the vertical drive circuit 111. The vertical drive circuit 111 controls the readout circuit 15b of each of the pixels P to thereby output the second pixel signal based on the electric charge generated by the photoelectric conversion section 11b from each of the pixels P to the signal line VSL2. The vertical drive circuit 111 may perform a control to read the second pixel signal of each of the pixels P to the signal line VSL2.

For example, the readout circuit 15c has a circuit configuration similar to that of the readout circuit 15a. The floating diffusion FD3 of the readout circuit 15c corresponds to the floating diffusion FD1 of the readout circuit 15a. An amplification transistor AMP3 in the readout circuit 15c corresponds to the amplification transistor AMP1 of the readout circuit 15a.

In addition, a selection transistor SEL3 corresponds to the selection transistor SEL1. A reset transistor RST3 corresponds to the reset transistor RST1. The readout circuit 15c may generate and output a signal based on the electric charge accumulated in the floating diffusion FD3, i.e., a signal (a third pixel signal) based on the electric charge converted by the photoelectric conversion section 11c.

The photoelectric conversion section 11c is electrically coupled to the readout circuit 15c via the through-electrode 50 described above. The readout electrode 24 of the photoelectric conversion section 11c is coupled to the floating diffusion FD3 via the through-electrode 50. Electric charge photoelectrically converted by the photoelectric conversion section 11c may be transferred to the floating diffusion FD3 from the photoelectric conversion section 11c via the through-electrode 50.

The selection transistor SEL3, the reset transistor RST3, and the like are controlled to be ON/OFF by the vertical drive circuit 111. The vertical drive circuit 111 controls the accumulation electrode 26, the readout circuit 15c, and the like of each of the pixels P to thereby output the third pixel signal based on the electric charge generated by the photoelectric conversion section 11c from each of the pixels P to the signal line VSL3. The vertical drive circuit 111 may perform a control to read the third pixel signal of each of the pixels P to the signal line VSL3.

In the example illustrated in FIG. 3, the photoelectric conversion section 11c, the photoelectric conversion section 11b, and the photoelectric conversion section 11a of the pixel P receive light incident from a subject as a measurement target via the lens 81. The photoelectric conversion section 11c may photoelectrically convert the light incident via the lens 81 to generate electric charge. For example, light having passed through the photoelectric conversion section 11c is incident on the photoelectric conversion section 11b of the pixel P. In the example illustrated in FIG. 3, light transmitted through the lens 81 and the photoelectric conversion section 11c is incident on the photoelectric conversion section 11b.

The photoelectric conversion section 11b may photoelectrically convert the light transmitted through the photoelectric conversion section 11c to generate electric charge. For example, light having passed through the photoelectric conversion section 11b is incident on the photoelectric conversion section 11a of the pixel P. In the example illustrated in FIG. 3, light transmitted through the lens 81, the photoelectric conversion section 11c, and the photoelectric conversion section 11b is incident on the photoelectric conversion section 11a. The photoelectric conversion section 11a may photoelectrically convert light transmitted through the photoelectric conversion section 11b to generate electric charge.

The imaging device 1 may obtain the first pixel signal based on the electric charge converted by photoelectric conversion section 11a, the second pixel signal based on the electric charge converted by photoelectric conversion section 11b, and the third pixel signal based on the electric charge converted by photoelectric conversion section 11c. It is to be noted that each of the photoelectric conversion section 11a, the photoelectric conversion section 11b, and the photoelectric conversion section 11c may be configured to receive and photoelectrically convert visible light, and may be configured to receive and photoelectrically convert infrared light (e.g., near-infrared light).

For example, the photoelectric conversion section 11a, the photoelectric conversion section 11b, and the photoelectric conversion section 11c may be configured to photoelectrically convert visible light beams of wavelength regions different from each other to generate electric charge. In addition, for example, the photoelectric conversion section 11a or the photoelectric conversion section 11b may be configured to photoelectrically convert infrared light to generate electric charge. Using the first pixel signal, the second pixel signal, and the third pixel signal of each of the pixels P makes it possible to generate a visible image (e.g., RGB image), an infrared image (IR image), and the like.

As an example, the photoelectric conversion section 11c of the pixel P receives and photoelectrically converts mainly light of a wavelength region of green (G), of light beams from a subject as a measurement target. The photoelectric conversion section 11b receives and photoelectrically converts mainly light of a wavelength region of blue (B). In addition, the photoelectric conversion section 11a receives and photoelectrically converts mainly light of a wavelength region of red (R).

Each of the pixels P of the imaging device 1 is able to generate a pixel signal of an R component, a pixel signal of a G component, and a pixel signal of a B component. It becomes possible for the imaging device 1 to obtain RGB pixel signals. It is to be noted that a wavelength region indicating sensitivity may be set optionally in each of the photoelectric conversion section 11a, the photoelectric conversion section 11b, and the photoelectric conversion section 11c.

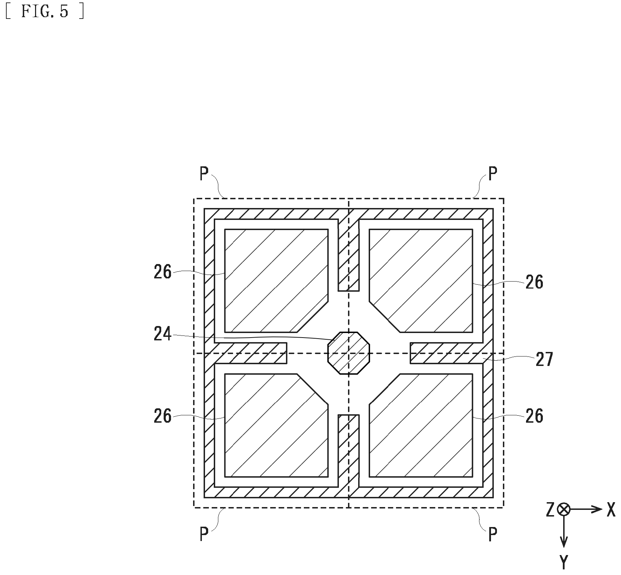

FIG. 5 is an explanatory diagram of an example of a planar configuration of the imaging device according to the first embodiment. The imaging device 1 may have a configuration in which a plurality of pixels P of any number (e.g., four) arranged in the row direction (horizontal direction) or in the column direction (vertical direction) shares the readout electrode 24, the readout circuit 15, and the like.

FIG. 5 exemplifies a case where respective photoelectric conversion sections 11c of the four pixels P adjacent to each other share one readout electrode 24. In the example illustrated in FIG. 5, the imaging device 1 has a configuration in which the photoelectric conversion sections 11c of the four pixels P of 2 × 2 pixels share the readout electrode 24 and the readout circuit 15c.

The readout electrode 24 is provided for the four photoelectric conversion sections 11c adjacent to each other. For example, at least a portion of the readout electrode 24 is provided at a boundary of the four pixels P. In the example illustrated in FIG. 5, the readout electrode 24 is disposed in a middle region of the four pixels P. The accumulation electrode 26 is provided for each of the photoelectric conversion sections 11c, for example.

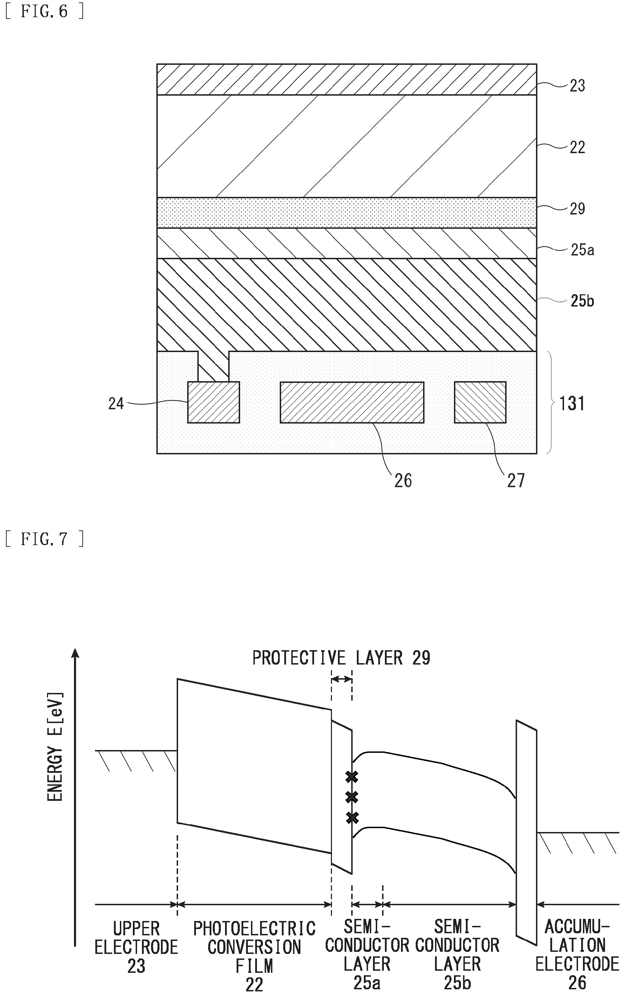

In addition, the imaging device 1 may include a shield electrode 27, as in the example illustrated in FIG. 5. The shield electrode 27 is provided around the accumulation electrode 26 in the insulating layer 131 (see also FIG. 6 as described later). The shield electrode 27 is provided for the photoelectric conversion film 22 for each of the pixels P or for every plurality of pixels P. The shield electrode 27 is supplied with a predetermined potential (voltage) via wiring, an electrode, and the like, for example.

As an example, the shield electrode 27 may be electrically coupled to wiring to which a constant voltage is to be applied, and may generate a potential barrier in the semiconductor layer 25b. Providing the shield electrode 27 suppresses leakage of the electric charge photoelectrically converted by the photoelectric conversion section 11c of the pixel P to surrounding pixels P.

The shield electrode 27 is a transparent electrode, for example, and is configured by a material that transmits light to be photoelectrically converted by the photoelectric conversion section. As an example, the shield electrode 27 is configured using ITO, IZO, or the like. The shield electrode 27 may be formed using another tin oxide-based material, zinc oxide-based material, or the like, or may be configured using another transparent electrically-conductive material. The shield electrode 27 may be configured using the same type of material as those of the readout electrode 24, the accumulation electrode 26, and the like, for example.

FIG. 6 is an explanatory diagram of a configuration example of the imaging device according to the first embodiment. In addition, FIG. 7 is a diagram illustrating an example of energy levels in the imaging device according to the first embodiment. FIG. 7 illustrates energy levels of the upper electrode 23, the photoelectric conversion film 22, the protective layer 29, the semiconductor layer 25a, the semiconductor layer 25b, and the accumulation electrode 26.

The imaging device 1 according to the present embodiment is provided with the semiconductor layer 25a, as illustrated in FIGs. 3 and 6 and other drawings. The semiconductor layer 25a has a carrier concentration higher than a carrier concentration in the semiconductor layer 25b, for example, as described above. This brings an interface state of the photoelectric conversion film 22 into a state filled with electric charge (electrons), thus making it possible to suppress mixing of noise caused by the interface state of the photoelectric conversion film 22 into a pixel signal.

In the imaging device 1, it is possible for the semiconductor layer 25a having a high carrier concentration to fill an interface state between the protective layer 29 and the semiconductor layer 25a with electrons, as schematically represented by signs "X" in FIG. 7. Accordingly, it is possible to suppress signal charge (electrons), having been photoelectrically converted by the photoelectric conversion film 22, being trapped (captured) at the interface state between the protective layer 29 and the semiconductor layer 25a.

In the imaging device 1, providing the semiconductor layer 25a makes it possible to reduce noise caused by an interface state, e.g., a noise component caused by electrons emitted in a delayed manner from the interface state. It is possible to suppress a decrease in the quality of the pixel signal (the third pixel signal described above), thus making it possible to suppress a decrease in the quality of an image to be generated using the pixel signal.

In addition, the imaging device 1 may be configured to allow the difference φ1 between the Fermi level and the energy level at the conduction band lower end in the semiconductor layer 25a is smaller than the difference φ2 between the Fermi level and the energy level at the conduction band lower end in the semiconductor layer 25b. This allows the semiconductor layer 25a and the semiconductor layer 25b to transfer electrons to a defect level of the interface between the protective layer 29 and the semiconductor layer 25a, thus making it possible to reduce an interface state not filled with electrons (i.e., vacant interface defect). It becomes possible to effectively suppress noise mixed into the pixel signal.

The difference between the vacuum level and the energy level at the conduction band lower end in the protective layer 29 may be smaller than the difference between the vacuum level and the energy level at the conduction band lower end in the semiconductor layer 25a. In addition, the protective layer 29 may have a thickness (film thickness) of 5 nm or less, for example. It is possible to suppress formation of an unnecessary potential barrier between the protective layer 29 and the semiconductor layer 25a. It becomes possible to suppress a decrease in efficiency of transferring electric charge generated by the photoelectric conversion film 22.

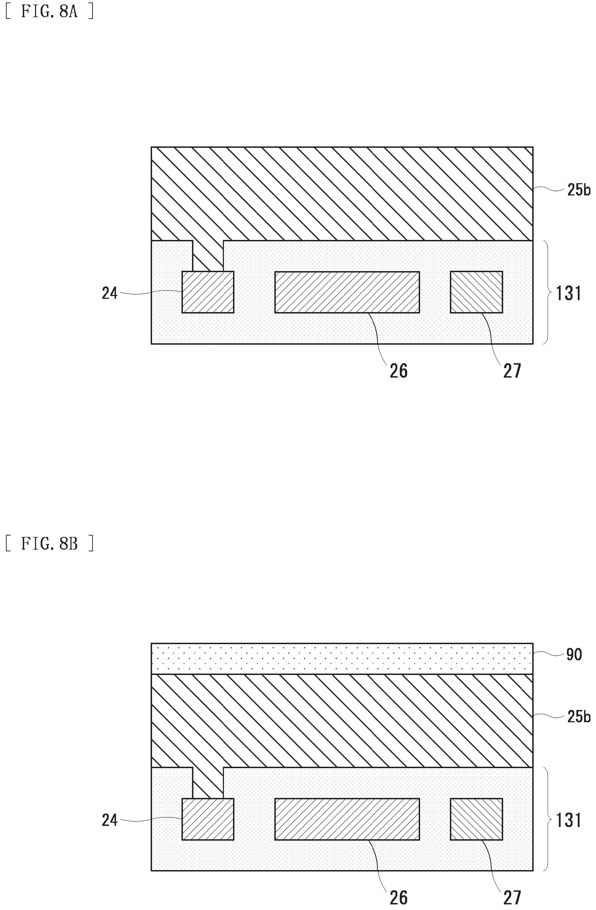

FIGs. 8A to 8D are each an explanatory diagram of an example of a method of manufacturing the imaging device according to the first embodiment. First, the readout electrode 24, the accumulation electrode 26, the shield electrode 27, and the like are sequentially formed on the semiconductor layer 110 in which the photoelectric conversion section 11a, the photoelectric conversion section 11b, and the like are formed.

Then, as illustrated in FIG. 8A, the semiconductor layer 25b is formed on the insulating layer 131 by sputtering or ALD (Atomic Vapor Deposition). For example, an IGZO film is formed as the semiconductor layer 25b. It is to be noted that an annealing treatment (e.g., 100°C to 600°C) may be performed after the formation of the semiconductor layer 25b.

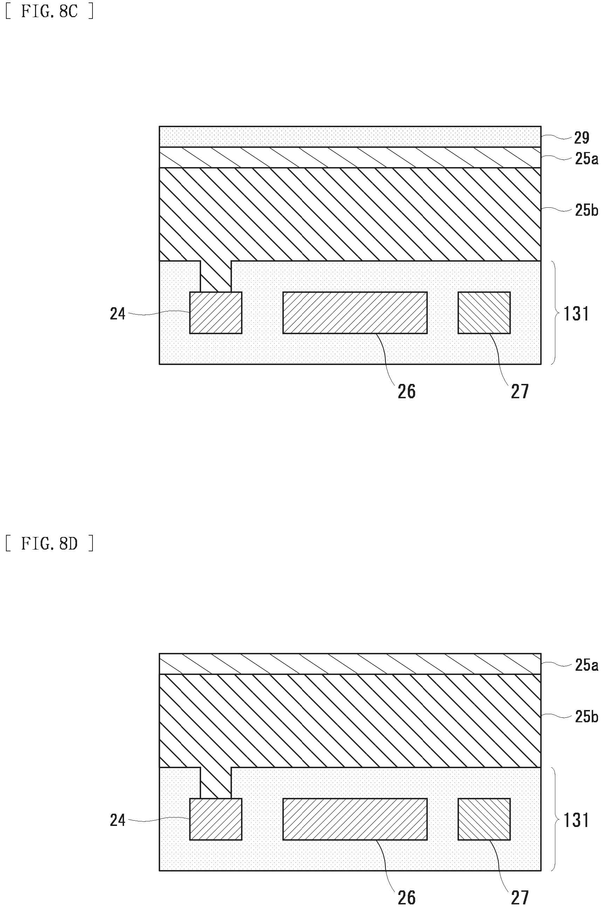

Next, as illustrated in FIG. 8B, an Al film 90 (aluminum film) is formed on the semiconductor layer 25b by sputtering. For example, the Al film 90 has a film thickness of about 5 nm. Then, performing an annealing treatment (e.g., 300°C to 400°C) allows for formation of the semiconductor layer 25a and the protective layer 29 configured by Al₂O₃, as illustrated in FIG. 8C.

The Al film 90 is formed on the semiconductor layer 25b including an IGZO film, and an annealing treatment is performed, thereby making it possible to form the semiconductor layer 25a having a high carrier concentration and the protective layer 29. Providing the protective layer 29, which includes Al₂O₃, on the semiconductor layer 25a makes it possible to improve sealability. In addition, a reduction in the interface defect is expectable.

As illustrated in FIG. 8D, the protective layer 29 may be removed by etching as needed. The photoelectric conversion film 22, the upper electrode 23, and the like are formed after the formation of the semiconductor layer 25a. The manufacturing method as described above enables the imaging device 1 illustrated in FIG. 3 and other drawings to be manufactured.

In the imaging device 1, a constituent element of the semiconductor layer 25a may be different from a constituent element of the semiconductor layer 25b. For example, the semiconductor layer 25a may contain an element (e.g., aluminum, in the above-described example with reference to FIGs. 8A to 8C and other drawings) different from the constituent element of the semiconductor layer 25b.

The semiconductor layer 25a may be configured to include a cation that constitutes the protective layer 29. As an example, in a case where the protective layer 29 is configured by Al₂O₃, the semiconductor layer 25a may be configured to contain, as a cation, aluminum that penetrates from the Al film 90 in the annealing treatment.

It is to be noted that the above-described manufacturing method is merely exemplary, and another manufacturing method may be adopted. In addition, the configuration of the imaging device 1 is not limited to the above-described example. Ga (gallium), In (indium), Sc (scandium), Y (yttrium), or the like may be formed, instead of the Al film 90, on the semiconductor layer 25b, and the semiconductor layer 25a may be formed by an annealing treatment.

In addition, the semiconductor layer 25a may be formed by an ALD method. As an example, ALD may be adopted to form a stacked film, as the semiconductor layer 25a, in which ZnO and Al₂O₃ are stacked. The semiconductor layer 25a and the semiconductor layer 25b may each be formed by Ga₂O₃ doped with Si, ZnO doped with Al, ZnO doped with Ga, or the like.

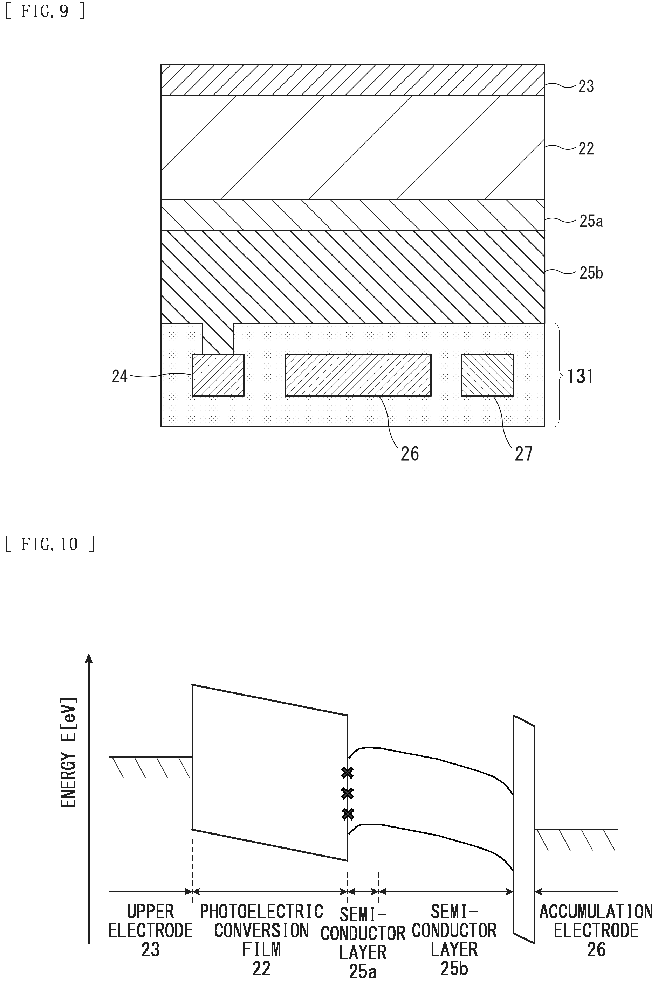

FIG. 9 is an explanatory diagram of another configuration example of the imaging device according to the first embodiment. The imaging device 1 may not include the protective layer 29, as in the example illustrated in FIG. 9. In addition, FIG. 10 is a diagram illustrating an example of energy levels in the imaging device. FIG. 10 illustrates respective energy levels of the upper electrode 23, the photoelectric conversion film 22, the semiconductor layer 25a, the semiconductor layer 25b, and the accumulation electrode 26. The semiconductor layer 25a is provided in contact with the photoelectric conversion film 22, for example.

In the imaging device 1, providing the semiconductor layer 25a having a high carrier concentration makes it possible to fill an interface state between the photoelectric conversion film 22 and the semiconductor layer 25a with electrons, as schematically represented by signs "X" in FIG. 10. Accordingly, it is possible to suppress signal charge (electrons), having been photoelectrically converted by the photoelectric conversion film 22, being trapped at the interface state between the photoelectric conversion film 22 and the semiconductor layer 25a. It is therefore possible to suppress mixing of noise caused by the interface state into the pixel signal.

In addition, the difference φ1 between the Fermi level and the energy level at the conduction band lower end in the semiconductor layer 25a may be smaller than the difference φ2 between the Fermi level and the energy level at the conduction band lower end in the semiconductor layer 25b. The semiconductor layer 25a and the semiconductor layer 25b transfer electrons to the interface state between the photoelectric conversion film 22 and the semiconductor layer 25a, thus making it possible to reduce an interface state not filled with electrons (vacant interface defect). It is possible to effectively suppress noise mixed into the pixel signal. It becomes possible to suppress a decrease in the quality of an image.

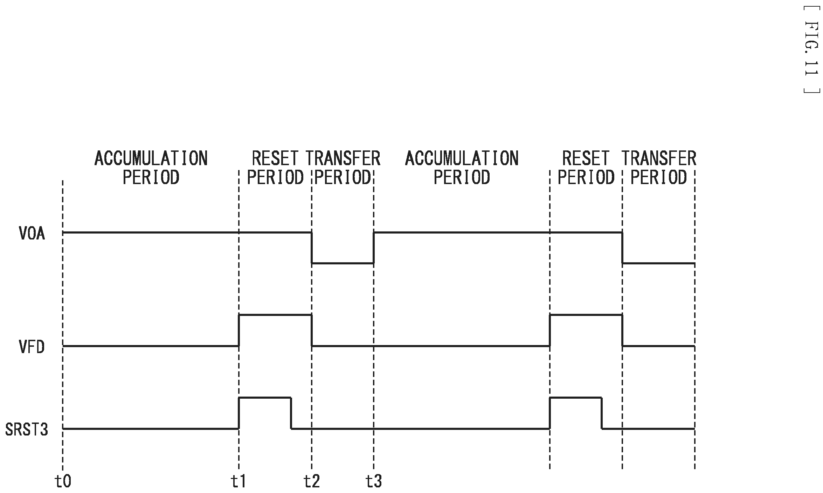

FIG. 11 is a timing chart illustrating an operation example of the imaging device according to the first embodiment. The timing chart illustrated in FIG. 11 schematically illustrates, with the horizontal axis being set as time, a voltage of the accumulation electrode 26 of the pixel P, a voltage of the floating diffusion FD3 (referred to as a voltage VFD), and a voltage of a signal SRST3 to be supplied to the reset transistor RST3.

In the imaging device 1, within a period from time t0 to time t2 illustrated in FIG. 11, the vertical drive circuit 111 applies a potential V1 to the readout electrode 24, and applies a potential V2 to the accumulation electrode 26. Here, V2 > V1 holds true for the potentials V1 and V2. Thus, electric charge (signal charge; electrons) generated by photoelectric conversion is attracted to the accumulation electrode 26 and accumulated in a region of the semiconductor layer 25b opposed to the accumulation electrode 26 (accumulation period).

At the time t1, the vertical drive circuit 111 changes the voltage of the signal SRST3 from a low level to a high level. This brings the reset transistor RST3 into an ON state in the pixel P to reset the voltage of the floating diffusion FD3 (reset period).

At the time t2, the vertical drive circuit 111 applies a potential V3 to the readout electrode 24, and applies a potential V4 to the accumulation electrode 26. Here, V3 > V4 holds true for the potentials V3 and V4. Thus, electric charge accumulated in a region corresponding to the accumulation electrode 26 is read from the readout electrode 24 to the floating diffusion FD3 (transfer period).

After completion of the reading operation, the vertical drive circuit 111 again applies the potential V1 to the readout electrode 24, and applies the potential V2 to the accumulation electrode 26. Thus, electric charge generated by photoelectric conversion is attracted to the accumulation electrode 26 and accumulated in a region of the semiconductor layer 25b opposed to the accumulation electrode 26 (accumulation period).

In the imaging device 1, for example, blue light (B), of light beams transmitted through the photoelectric conversion section 11c, is absorbed by the photoelectric conversion section 11b, and red light (R) thereof is absorbed by the photoelectric conversion section 11a, in order; the blue light (B) and the red light (R) are then photoelectrically converted. In the photoelectric conversion section 11b, electrons corresponding to the incident blue light (B) are accumulated in the photoelectric conversion section 11b, and the accumulated electrons are transferred by the transfer transistor TR2 to the floating diffusion FD2. In addition, in the photoelectric conversion section 11a, electrons corresponding to the incident red light (R) are accumulated in the photoelectric conversion section 11a, and the accumulated electrons are transferred by the transfer transistor TR1 to the floating diffusion FD1.

### [Workings and Effects]

The light detecting device according to the present embodiment includes: a first electrode (e.g., upper electrode 23); a second electrode (e.g., accumulation electrode 26) provided to be opposed to the first electrode; a photoelectric conversion film (photoelectric conversion film 22) provided between the first electrode and the second electrode; a first semiconductor layer (semiconductor layer 25a) provided between the photoelectric conversion film and the second electrode; and a second semiconductor layer (semiconductor layer 25b) provided between the first semiconductor layer and the second electrode. A difference between a Fermi level and an energy level at a conduction band lower end in the first semiconductor layer is smaller than a difference between a Fermi level and an energy level at a conduction band lower end in the second semiconductor layer.

In the light detecting device (imaging device 1) according to the present embodiment, the difference between the Fermi level and the energy level at the conduction band lower end in the semiconductor layer 25a is smaller than the difference between the Fermi level and the energy level at the conduction band lower end in the semiconductor layer 25b. This makes it possible to suppress noise caused by the interface state and thus to suppress a decrease in the quality of the pixel signal. It becomes possible to achieve a light detecting device that makes it possible to suppress a decrease in signal quality.

The light detecting device according to the present embodiment includes: a first electrode (e.g., upper electrode 23); a second electrode (e.g., accumulation electrode 26) provided to be opposed to the first electrode; a photoelectric conversion film (photoelectric conversion film 22) provided between the first electrode and the second electrode; a first semiconductor layer (semiconductor layer 25a) provided between the photoelectric conversion film and the second electrode; and a second semiconductor layer (semiconductor layer 25b) provided between the first semiconductor layer and the second electrode. A carrier concentration in the first semiconductor layer is higher than a carrier concentration in the second semiconductor layer.

The light detecting device (imaging device 1) according to the present embodiment is provided with the semiconductor layer 25a. The carrier concentration in the semiconductor layer 25a is higher than the carrier concentration in the semiconductor layer 25b. This makes it possible to suppress noise caused by the interface state. It becomes possible to achieve a light detecting device that makes it possible to suppress a decrease in signal quality.

Next, description is given of modification examples of the present disclosure. Hereinafter, components similar to those of the foregoing embodiment are denoted by the same reference numerals, and descriptions thereof are omitted as appropriate.

### (Modification Example 1)

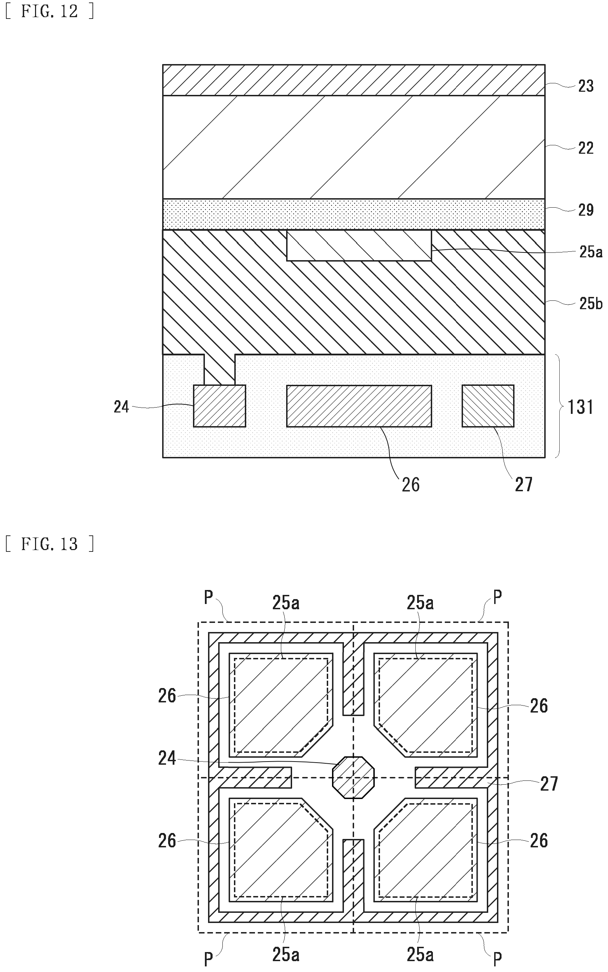

FIG. 12 is an explanatory diagram of an example of a cross-sectional configuration of an imaging device according to Modification Example 1 of the present disclosure. In addition, FIG. 13 is an explanatory diagram of an example of a planar configuration of the imaging device. As in the example illustrated in FIGs. 12 and 13, the semiconductor layer 25a may be provided in a region part opposed to the accumulation electrode 26. As in the example illustrated in FIG. 13, the semiconductor layer 25a is provided, in a plan view, to overlap the accumulation electrode 26.

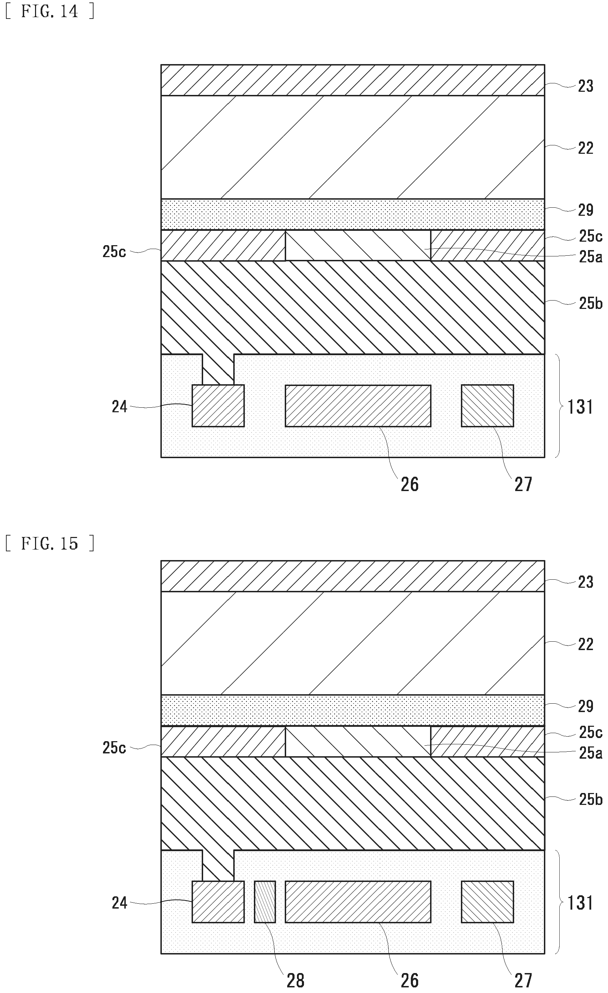

FIG. 14 is an explanatory diagram of another configuration example of the imaging device according to Modification Example 1. The imaging device 1 may be provided with a semiconductor layer 25c different from the semiconductor layer 25b in a peripheral region of the semiconductor layer 25a. The semiconductor layer 25c is provided to be adjacent to the semiconductor layer 25a, for example, as in the example illustrated in FIG. 14. The semiconductor layer 25a and the semiconductor layer 25c may each be selectively formed by ion implantation, plasma doping, solid-phase diffusion, or the like, for example.

In the example illustrated in FIG. 14, the semiconductor layer 25c is formed in each of a region part opposed to the readout electrode 24 and a region part opposed to the shield electrode 27. The semiconductor layer 25a has a carrier concentration higher than a carrier concentration in the semiconductor layer 25c, for example. In addition, the difference between the Fermi level and the energy level at the conduction band lower end in the semiconductor layer 25a may be smaller than a difference between a Fermi level and an energy level at a conduction band lower end in the semiconductor layer 25c.

FIG. 15 is an explanatory diagram of another configuration example of the imaging device according to Modification Example 1. As illustrated in FIG. 15, each of the pixels P of the imaging device 1 may include a control electrode 28. For example, the vertical drive circuit 111 of the imaging device 1 controls a voltage to be supplied to the control electrode 28, thereby making it possible to adjust a potential at the photoelectric conversion section 11c. In the imaging device 1, it is possible for the accumulation electrode 26 and the readout electrode 24 to efficiently perform accumulation, transmission, and the like of electric charge.

### (Modification Example 2)

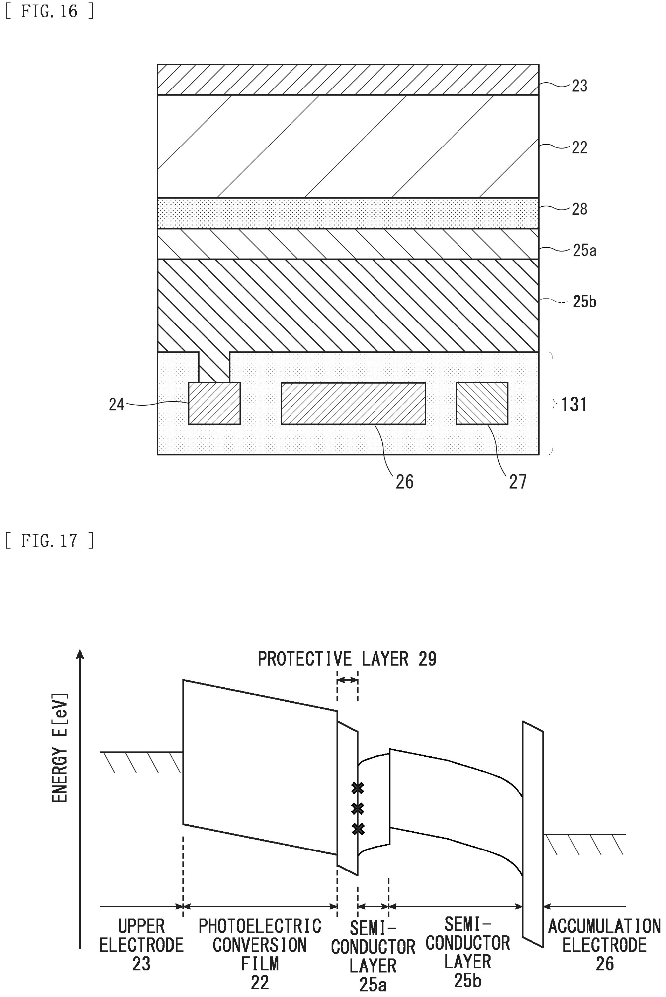

FIG. 16 is an explanatory diagram of an example of a cross-sectional configuration of an imaging device according to Modification Example 2. In addition, FIG. 17 is a diagram illustrating an example of energy levels in the imaging device. The semiconductor layer 25a and the semiconductor layer 25b may be configured by different materials. As in the example illustrated in FIG. 17, the energy level at the conduction band lower end in the semiconductor layer 25a may be deeper (smaller) than the energy level at the conduction band lower end in the semiconductor layer 25b.

Also in the case of the present modification example, the semiconductor layer 25a and the semiconductor layer 25b enable the interface state to be brought into a state filled with electrons, thus making it possible to suppress mixing of noise caused by the interface state into the pixel signal. It becomes possible to reduce a noise component mixed into the pixel signal, and thus to prevent deterioration in the quality of an image.

### (Modification Example 3)

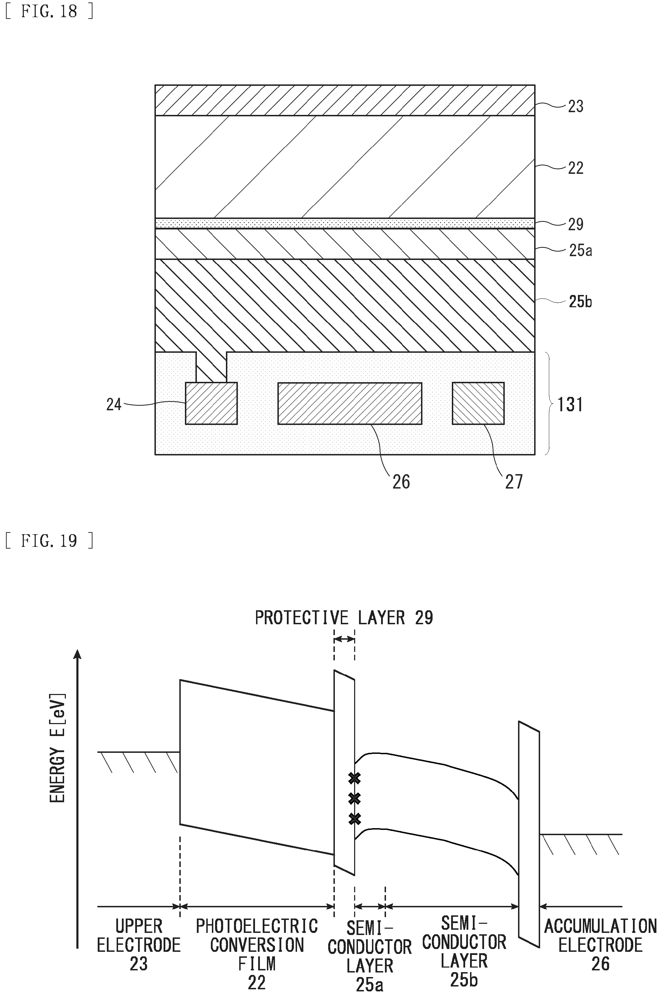

FIG. 18 is an explanatory diagram of an example of a cross-sectional configuration of an imaging device according to Modification Example 3. In addition, FIG. 19 is a diagram illustrating an example of energy levels in the imaging device. The protective layer 29 may be configured as a thin tunnel layer, as in the example schematically illustrated in FIGs. 18 and 19. The protective layer 29 may have a thickness (film thickness) of 5 nm or less, for example. Also in the case of the present modification example, it is possible to obtain effects similar to those of the foregoing embodiment.

### (Modification Example 4)

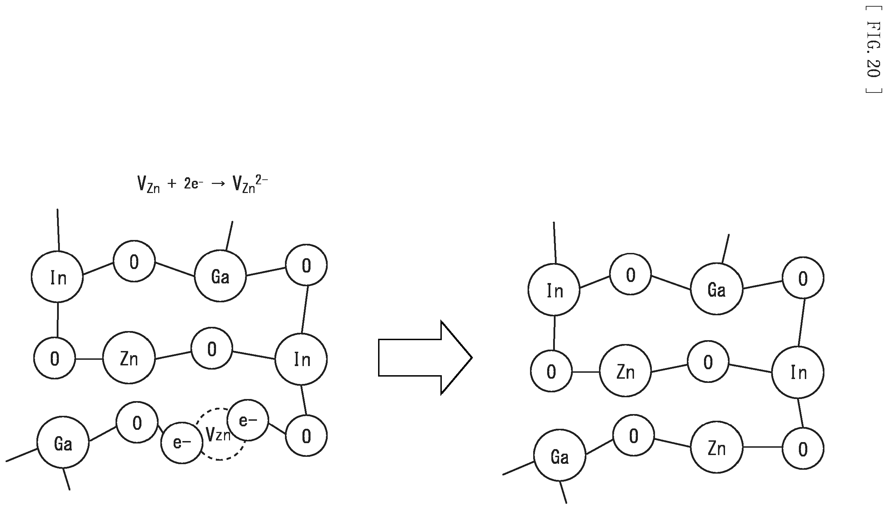

FIG. 20 is an explanatory diagram of a configuration example of an imaging device according to Modification Example 4. The semiconductor layer 25a and the semiconductor layer 25b may each be an oxide semiconductor layer containing Zn (zinc). A smaller (lower) Zn composition ratio tends to cause generation of a larger number of Zn vacancies that capture electrons, as schematically illustrated in FIG. 20.

Therefore, in the imaging device 1, the Zn composition ratio in the semiconductor layer 25a may be larger than the Zn composition ratio in the semiconductor layer 25b. Making the Zn composition ratio in the semiconductor layer 25a larger (higher) enables the carrier concentration in the semiconductor layer 25a to be larger. The increase in the carrier concentration does not result from the defect, thus making it possible to improve the reliability of the device.

In the light detecting device according to the present modification example, the first semiconductor layer and the second semiconductor layer (the semiconductor layer 25a and the semiconductor layer 25b) are each an oxide semiconductor layer containing Zn. The Zn composition ratio in the first semiconductor layer is larger than the Zn composition ratio in the second semiconductor layer. This makes it possible to suppress noise caused by the interface state and thus to suppress a decrease in the quality of the pixel signal. In addition, it becomes possible to improve the reliability of the device.

### (Modification Example 5)

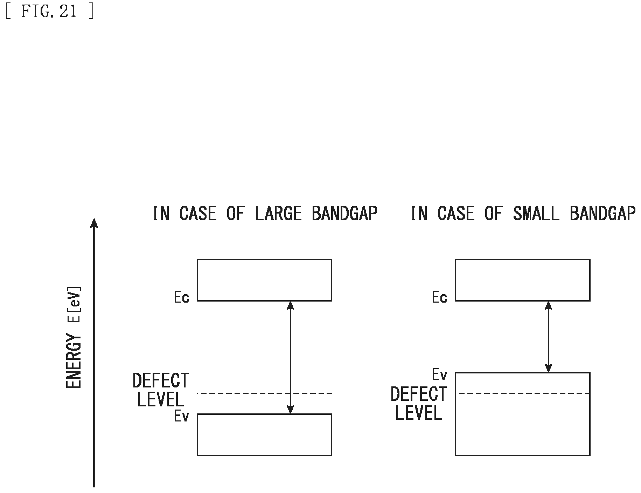

FIG. 21 is an explanatory diagram of a configuration example of an imaging device according to Modification Example 5. As schematically illustrated in FIG. 21, a larger band gap of the semiconductor layer may possibly bring a larger number of defect levels (e.g., an interface state of the photoelectric conversion film 22 or the protective layer 29) into a state not filled with electrons. Therefore, the semiconductor layer 25a may be configured to have a relatively small band gap.

The bandgap of the semiconductor layer 25a may be smaller than a bandgap of the semiconductor layer 25b, for example. The semiconductor layer 25a may be configured by a material having a bandgap smaller than the bandgap of the semiconductor layer 25b. Configuring the imaging device 1 in such a manner makes it possible to increase the carrier concentration in the semiconductor layer 25a, thus enabling the defect level to be filled with electrons, as schematically illustrated in FIG. 21.

In the imaging device 1, an energy level at a conduction band lower end in the photoelectric conversion film 22 may be larger than the energy level at the conduction band lower end in the semiconductor layer 25a. In addition, the energy level at the conduction band lower end in the semiconductor layer 25a may be larger than the energy level at the conduction band lower end in the semiconductor layer 25b. Also in the case of the imaging device 1 according to the present modification example, it is possible to obtain effects similar to those of the foregoing embodiment.

In addition, an energy level at a valence band upper end in the protective layer 29 of the imaging device 1 may be larger than an energy level of a valence band upper end in the semiconductor layer 25a. In this case, it is possible to reduce a defect level not filled with electrons. It is possible to suppress noise mixed into the pixel signal, and thus to suppress a decrease in the quality of an image.

In the light detecting device according to the present modification example, a bandgap in the first semiconductor layer (semiconductor layer 25a) is smaller than a bandgap in the second semiconductor layer (semiconductor layer 25b). This makes it possible to suppress generation of noise caused by the interface state. It becomes possible to achieve a light detecting device that makes it possible to suppress a decrease in signal quality.

### (Modification Example 6)

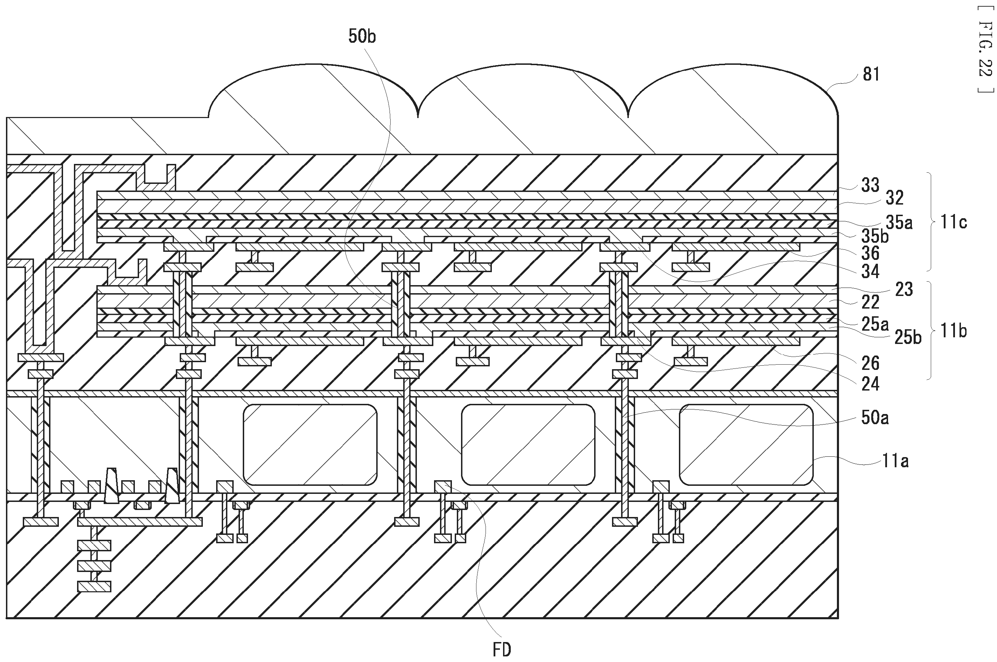

The description has been given, in the foregoing embodiment and modification examples, of the configuration example of the imaging device 1; however, the configuration of the imaging device 1 is merely exemplary, and is not limited to the above-described examples. FIG. 22 is an explanatory diagram of a configuration example of an imaging device according to Modification Example 6. As illustrated in FIG. 22, the imaging device 1 according to the present modification example includes a structure in which the photoelectric conversion section 11a, the photoelectric conversion section 11b, and the photoelectric conversion section 11c are stacked. The photoelectric conversion section 11c, the photoelectric conversion section 11b, and the photoelectric conversion section 11a are provided from the light incident side.

The photoelectric conversion section 11b includes, for example, the photoelectric conversion film 22, the upper electrode 23, the readout electrode 24, the semiconductor layer 25a, the semiconductor layer 25b, and the accumulation electrode 26, which are described above. In addition, the photoelectric conversion section 11c is provided to be stacked on the photoelectric conversion section 11b. The photoelectric conversion section 11c may have a configuration similar to that of the photoelectric conversion section 11b.

The photoelectric conversion section 11c includes, for example, a photoelectric conversion film 32, an upper electrode 33, a readout electrode 34, a semiconductor layer 35a, a semiconductor layer 35b, and an accumulation electrode 36. The photoelectric conversion film 32, the upper electrode 33, and the readout electrode 34 of photoelectric conversion section 11c correspond, respectively, to the photoelectric conversion film 22, the upper electrode 23, and the readout electrode 24 of the photoelectric conversion section 11b. The semiconductor layer 35a, the semiconductor layer 35b, and the accumulation electrode 36 of the photoelectric conversion section 11c correspond, respectively, to the semiconductor layer 25a, the semiconductor layer 25b, and the accumulation electrode 26 of the photoelectric conversion section 11b.

The photoelectric conversion section 11a, the photoelectric conversion section 11b, and the photoelectric conversion section 11c are configured, for example, to selectively detect light beams of wavelength regions different from one another to perform photoelectric conversion. As an example, the photoelectric conversion section 11b acquires a pixel signal of a green (G) color component. The photoelectric conversion section 11c acquires a pixel signal of a blue (B) color component. In addition, the photoelectric conversion section 11a acquires a pixel signal of a red (R) color component. This enables the imaging device 1 to acquire a plurality of types of color signals in one pixel.

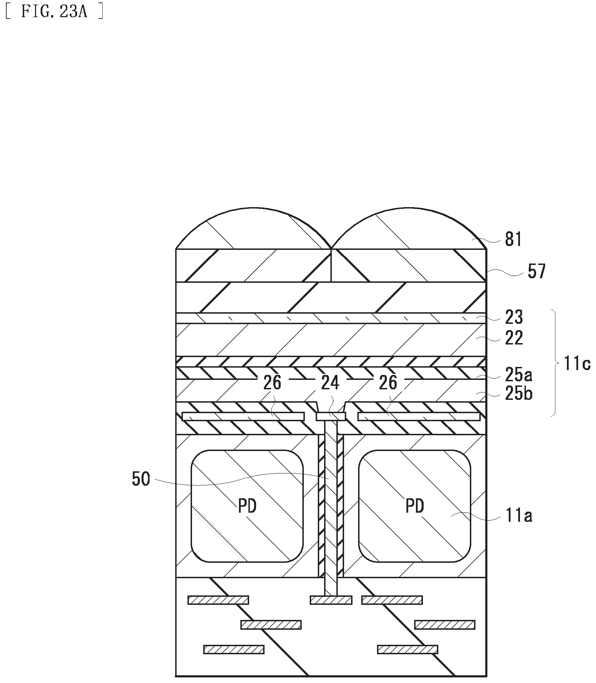

FIG. 23A is an explanatory diagram of another configuration example of the imaging device according to Modification Example 6. As illustrated in FIG. 23A, the imaging device 1 may have a structure in which the photoelectric conversion section 11a and the photoelectric conversion section 11c are stacked. In addition, the imaging device 1 may be provided with a filter 57. The filter 57 is configured to selectively transmit light of a specific wavelength region of incident light.

The filter 57 is provided between the lens 81 and the photoelectric conversion section 11c, for example. The filter 57 is a color filter of RGB, a filter that transmits infrared light, or the like. The filter 57 is provided above the photoelectric conversion section 11c, for example, for each of the pixels P or for every plurality of pixels P (i.e., for every predetermined number of pixels P).

As an example, the plurality of pixels P provided in the pixel section 100 (see FIGs. 1 and 2) of the imaging device 1 includes a pixel Pr (R pixel) provided with the filter 57 that transmits red (R) light, a pixel Pg (G pixel) provided with the filter 57 that transmits green (G) light, and a pixel Pb (B pixel) provided with the filter 57 that transmits blue (B) light. In the pixel section 100, a plurality of pixels Pr, a plurality of pixels Pg, and a plurality of pixels Pb are repeatedly arranged. As an example, the pixel Pr, the pixel Pg, and the pixel Pb are arranged in accordance with a Bayer arrangement.

The pixel Pr, the pixel Pg, and the pixel Pb of the pixel section 100 may generate an R component pixel signal, a G component pixel signal, and a B component pixel signal, respectively. The imaging device 1 is able to obtain RGB pixel signals. It is to be noted that the filter 57 may be disposed between the photoelectric conversion section 11b and the photoelectric conversion section 11a.

In the imaging device 1, for example, light beams of a visible light region (red light (R), green light (G), and blue light (B)), of the light transmitted through the filter 57, are each absorbed by the photoelectric conversion section 11c of each of the pixels P and photoelectrically converted. The photoelectric conversion section 11a of each of the pixels P may be configured to photoelectrically convert infrared light (IR) transmitted through the photoelectric conversion section 11c. It becomes possible to generate both of a visible light image and an infrared light image.

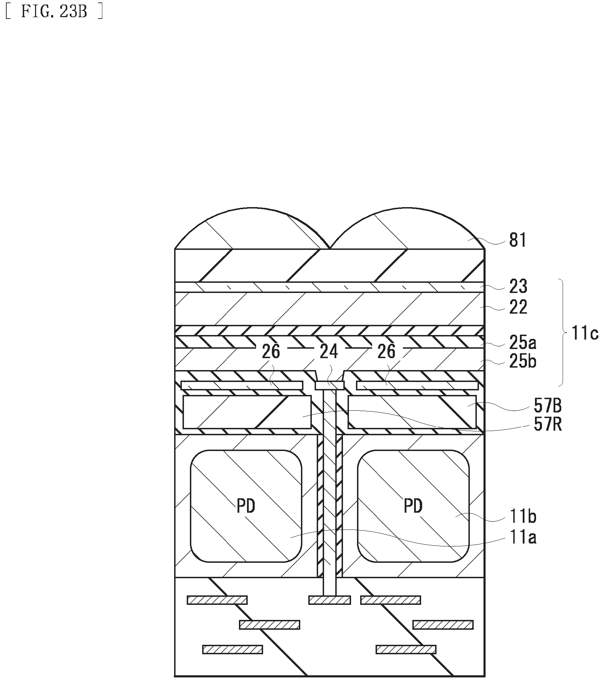

FIG. 23B is an explanatory diagram of another configuration example of the imaging device according to Modification Example 6. As in the example illustrated in FIG. 23B, the filter 57 may be provided between the photoelectric conversion section 11c and the photoelectric conversion section 11a (or the photoelectric conversion section 11b). In the imaging device 1, for example, the filter 57 (a filter 57R) that selectively transmits at least red light (R) and the filter 57 (a filter 57B) that selectively transmits at least blue light (B) may be disposed.

The photoelectric conversion section 11c is configured to selectively absorb light having a wavelength corresponding to green light (G), for example. The photoelectric conversion section 11a selectively absorbs light having a wavelength corresponding to red light (R), and the photoelectric conversion section 11b selectively absorbs light having a wavelength corresponding to blue light (B). This makes it possible to acquire a signal corresponding to red light (R), green light (G), or blue light (B). It is possible to increase an area of a photoelectric conversion section of each of RGB, as compared with a case of the typical Bayer arrangement, and thus to improve S/N ratio.

### <2. Second Embodiment>

Next, description is given of a second embodiment of the present disclosure. Hereinafter, components similar to those of the foregoing embodiment are denoted by the same reference numerals, and descriptions thereof are omitted as appropriate.

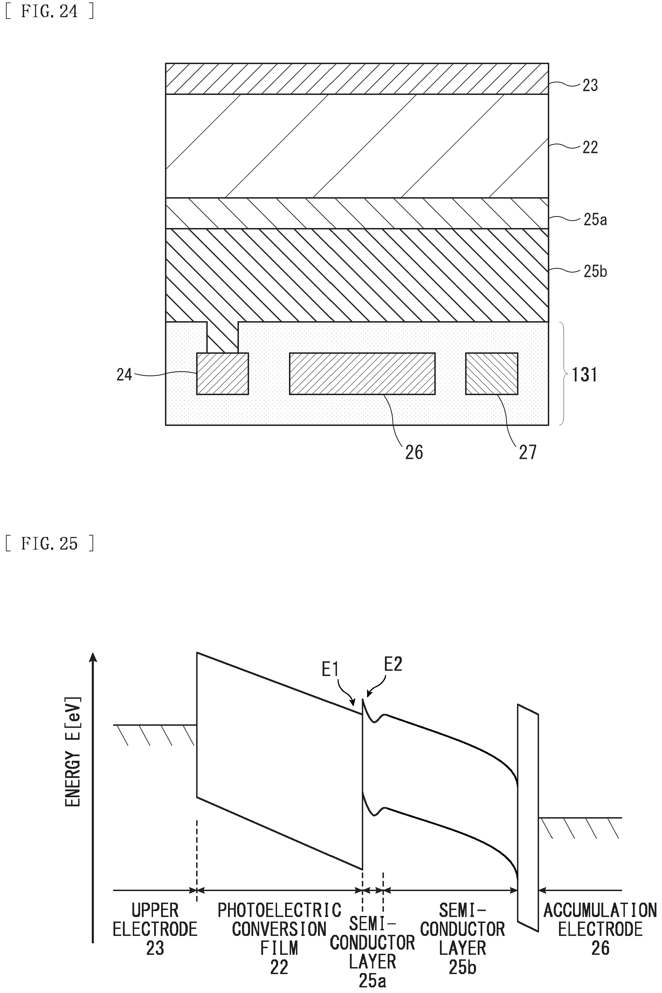

FIG. 24 is an explanatory diagram of a configuration example of an imaging device according to the second embodiment of the present disclosure. In addition, FIG. 25 is a diagram illustrating an example of energy levels in the imaging device. The semiconductor layer 25a of the imaging device 1 is configured to have a high carrier concentration (carrier density). The semiconductor layer 25a is configured to have a carrier concentration higher (larger) than a carrier concentration of the semiconductor layer 25b, for example.

In addition, the imaging device 1 may be configured to allow a difference between a vacuum level and an energy level at a conduction band lower end in the photoelectric conversion film 22 on a side of the semiconductor layer 25a is larger than a difference between a vacuum level and an energy level at a conduction band lower end in the semiconductor layer 25a on a side of the photoelectric conversion film 22. In the example illustrated in FIG. 25, a difference between the vacuum level and an energy level E1 at the conduction band lower end in the photoelectric conversion film 22 on the side of the semiconductor layer 25a is larger than a difference between the vacuum level and an energy level E2 at the conduction band lower end in the semiconductor layer 25a on the side of the photoelectric conversion film 22.

In the imaging device 1, the photoelectric conversion film 22 and the semiconductor layer 25a are provided in contact with each other with band bending, for example, as in the example illustrated in FIG. 25. Configuring the imaging device 1 in such a manner makes it possible to reduce a tunnel distance between the photoelectric conversion film 22 and the semiconductor layer 25a, for example, thus making it possible to suppress deterioration in efficiency of transferring signal charge (e.g., electrons).

In the imaging device 1 according to the present embodiment, it is possible to intensify (i.e., abruptly change) the band bending in the semiconductor layer 25a. It is therefore possible to suppress inhibition of electron transportation and to suppress a decrease in light utilization efficiency. In addition, it becomes possible to suppress generation of noise caused by the interface state.

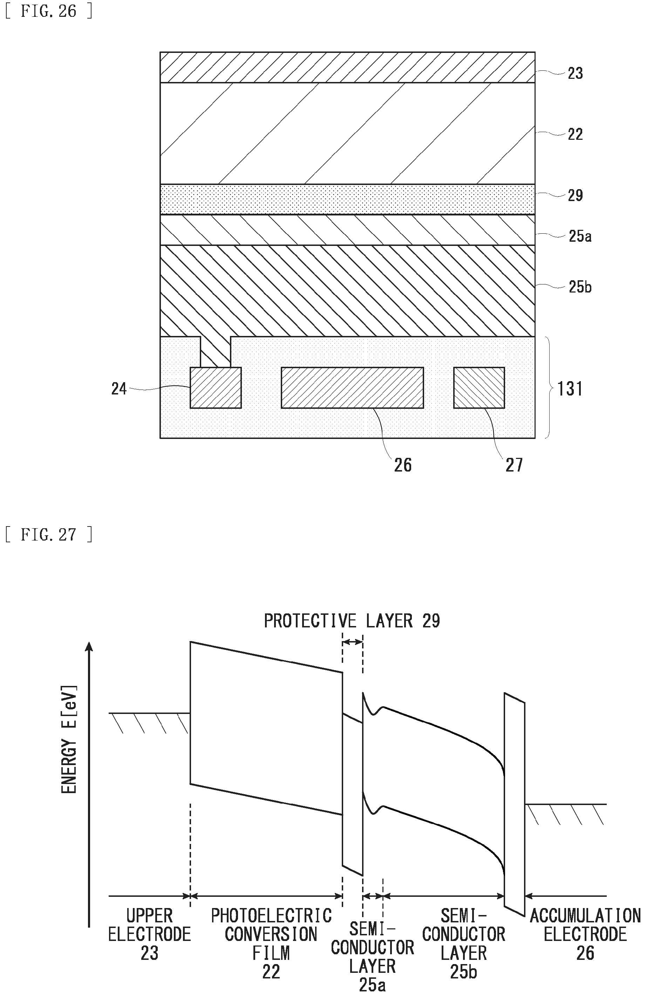

FIG. 26 is an explanatory diagram of another configuration example of the imaging device according to the second embodiment. As in the example illustrated in FIG. 26, the imaging device 1 may include the protective layer 29. In addition, FIG. 27 is a diagram illustrating an example of energy levels in the imaging device. FIG. 27 illustrates respective energy levels of the upper electrode 23, the photoelectric conversion film 22, the protective layer 29, the semiconductor layer 25a, the semiconductor layer 25b, and the accumulation electrode 26.

The protective layer 29 is, for example, a protective layer including an inorganic material, and is provided between the photoelectric conversion film 22 and the semiconductor layer 25a. In the example illustrated in FIG. 26, the protective layer 29 is formed between the photoelectric conversion film 22 and the semiconductor layer 25a, and is positioned on the semiconductor layer 25a.

In the imaging device 1, a difference between a vacuum level and an energy level at a conduction band lower end in the protective layer 29 on the side of the semiconductor layer 25a may be larger than a difference between a vacuum level and an energy level at a conduction band lower end in the semiconductor layer 25a on a side of the protective layer 29. It is possible to reduce a tunnel distance between the protective layer 29 and the semiconductor layer 25a, thus making it possible to suppress a decrease in efficiency of transporting electric charge generated by the photoelectric conversion film 22.

### [Workings and Effects]

In the light detecting device (imaging device 1) according to the present embodiment, a difference between a vacuum level and an energy level at a conduction band lower end in the photoelectric conversion film (photoelectric conversion film 22) on a side of the first semiconductor layer (semiconductor layer 25a) is larger than a difference between a vacuum level and an energy level at a conduction band lower end in the first semiconductor layer on a side of the photoelectric conversion film.

In the light detecting device (imaging device 1) according to the present embodiment, providing the semiconductor layer 25a makes it possible to suppress a decrease in efficiency of transporting electric charge. This makes it possible to achieve a light detecting device that makes it possible to suppress a decrease in signal quality.

Next, description is given of modification examples of the present disclosure. Hereinafter, components similar to those of the foregoing embodiments are denoted by the same reference numerals, and descriptions thereof are omitted as appropriate.

### (Modification Example 7)

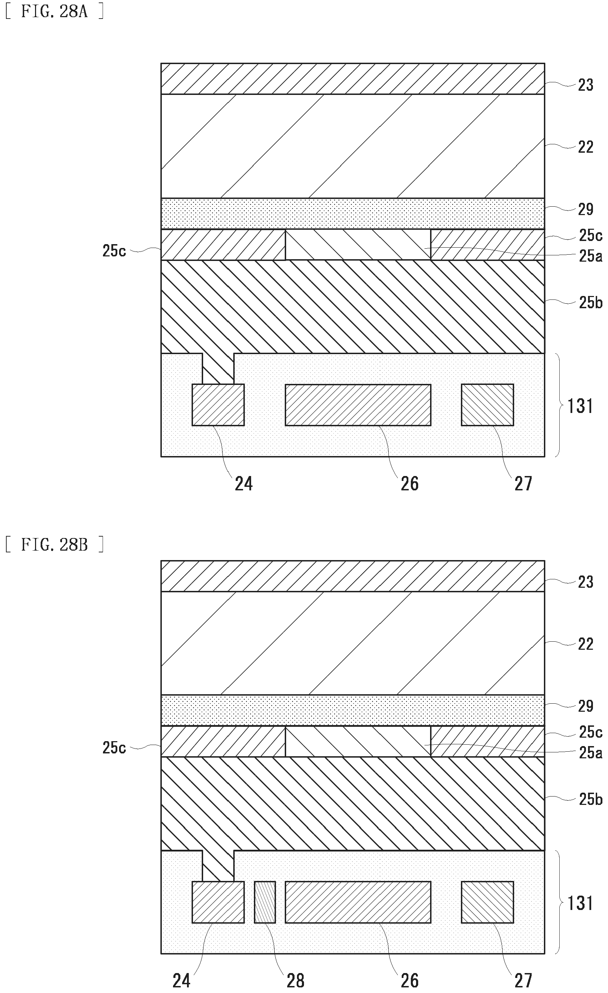

FIGs. 28A and 28B are each an explanatory diagram of an example of a cross-sectional configuration of an imaging device according to Modification Example 7 of the present disclosure. The semiconductor layer 25a may be provided in a region part opposed to the accumulation electrode 26, as in the example illustrated in FIG. 28A or 28B. In addition, the imaging device 1 may be provided with the semiconductor layer 25c in a region around the semiconductor layer 25a. In addition, the imaging device 1 may include the control electrode 28, as in the example illustrated in FIG. 25B.

### (Modification Example 8)

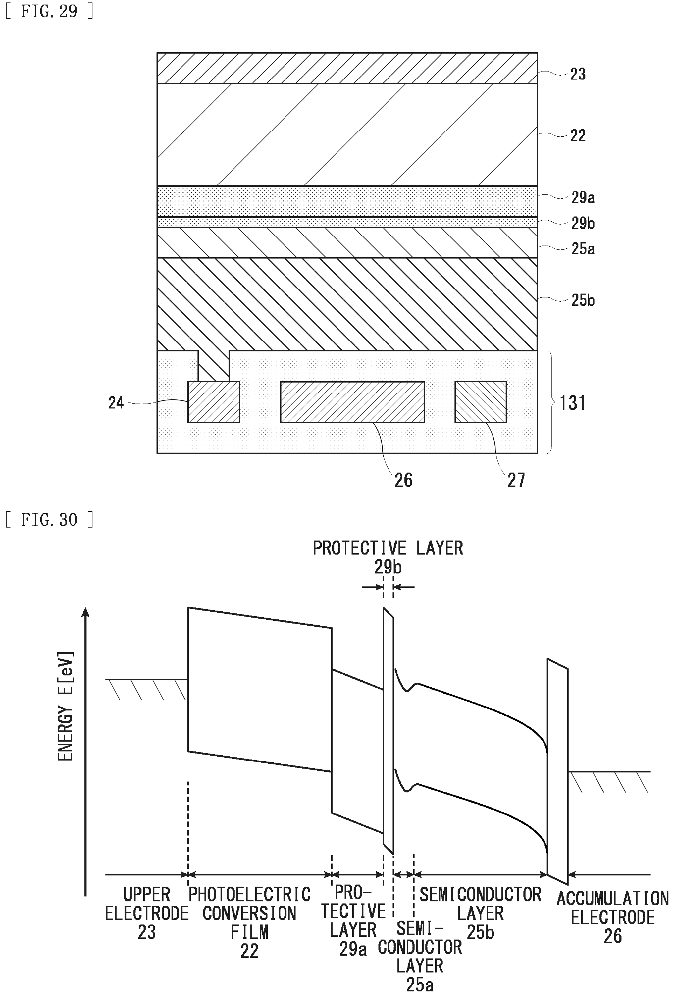

FIG. 29 is an explanatory diagram of an example of a cross-sectional configuration of an imaging device according to Modification Example 8. The imaging device 1 may include a plurality of protective layers 29 (a protective layer 29a and a protective layer 29b in FIG. 29). FIG. 30 is a diagram illustrating an example of energy levels in the imaging device. FIG. 30 illustrates respective energy levels of the upper electrode 23, the photoelectric conversion film 22, the protective layer 29a, the protective layer 29b, the semiconductor layer 25a, the semiconductor layer 25b, and the accumulation electrode 26.

Each of the protective layer 29a and the protective layer 29b is, for example, a protective layer including an inorganic material, and is provided between the photoelectric conversion film 22 and the semiconductor layer 25a. The protective layer 29a and the protective layer 29b each contain at least one of Ti, Si, Zr, Nb, V, Ta, Hf, Al, Sn, Sc, Y, La, Ga, or Mg, for example.

In the example illustrated in FIG. 29, the protective layer 29a is formed between the photoelectric conversion film 22 and the protective layer 29b, and is positioned on the protective layer 29b. The protective layer 29b is formed between the protective layer 29a and the semiconductor layer 25a, and is positioned on the semiconductor layer 25a. The protective layer 29a and the protective layer 29b may be provided to be stacked on each other. It is to be noted that the protective layer 29a and the protective layer 29b may be configured using the same type of materials, or may be configured using different materials.

In the imaging device 1, a difference between a vacuum level and an energy level at a conduction band lower end of the protective layer 29b may be smaller than a difference between a vacuum level and the energy level at the conduction band lower end of the semiconductor layer 25a. The protective layer 29b may be configured as a tunnel layer, for example. The protective layer 29b may have a thickness of 5 nm or less. Also in the case of the present modification example, it is possible to obtain effects similar to those of the foregoing embodiments.

### <3. Application Examples>

### (Application Example 1)

The above-described light detecting device (imaging device 1) is applicable, for example, to various types of electronic apparatuses including an imaging system such as a digital still camera and a video camera, a mobile phone having an imaging function, or another device having an imaging function.

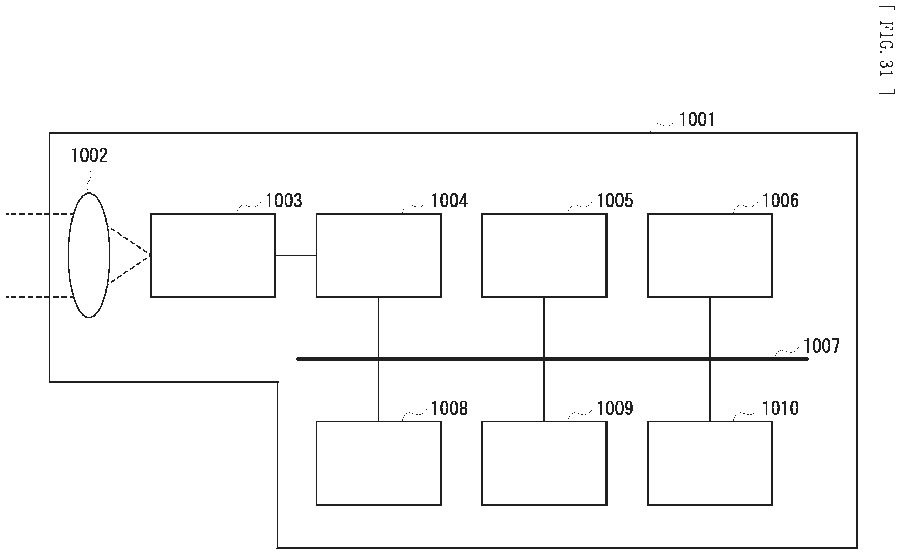

FIG. 31 is a block diagram illustrating a configuration example of an electronic apparatus.

As illustrated in FIG. 31, an electronic apparatus 1001 includes an optical system 1002, a light detecting device 1003, and a DSP (Digital Signal Processor) 1004, and has a configuration in which the DSP 1004, a display device 1005, an operation system 1006, a memory 1008, a recording device 1009, and a power supply system 1010 are coupled together via a bus 1007, thus making it possible to capture a still image and a moving image.

The optical system 1002 includes one or a plurality of lenses, and guides image light (incident light) from a subject to the light detecting device 1003 to form an image on a light-receiving surface (sensor section) of the light detecting device 1003.

The above-described light detecting device (imaging device 1) is applicable as the light detecting device 1003. The light detecting device 1003 accumulates electrons for a certain period of time in response to an image formed on the light-receiving surface via the optical system 1002. Then, the DSP 1004 is supplied with signals corresponding to the electrons accumulated in the light detecting device 1003.

The DSP 1004 performs various types of signal processing on the signals from the light detecting device 1003 to acquire an image, and causes the memory 1008 to temporarily store data on the image. The image data stored in the memory 1008 is recorded in the recording device 1009, or is supplied to the display device 1005 to display the image. In addition, the operation system 1006 receives various operations by a user, and supplies operation signals to the respective blocks of the electronic apparatus 1001. The power supply system 1010 supplies electric power required to drive the respective blocks of the electronic apparatus 1001.

### (Application Example 2)

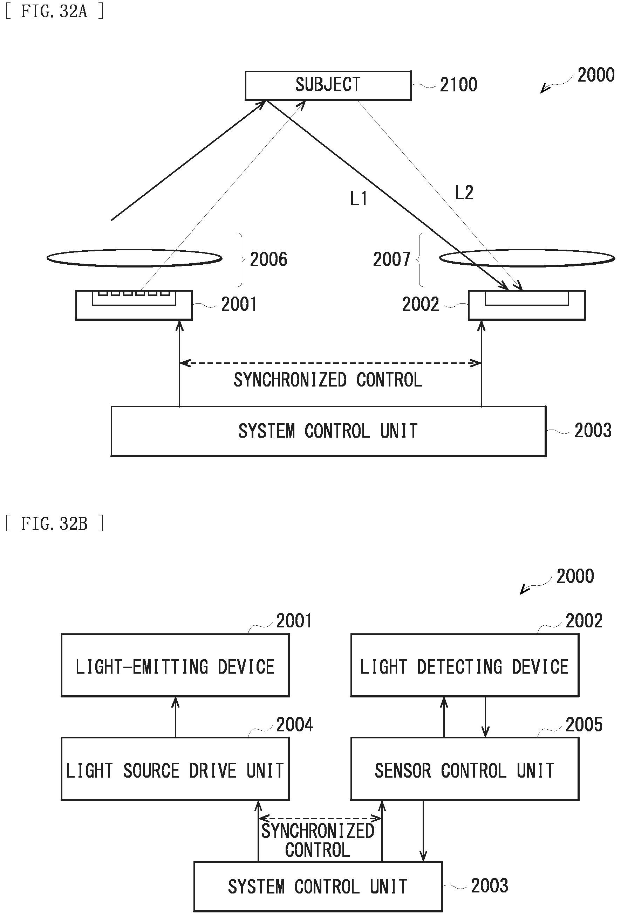

FIG. 32A schematically illustrates an example of an overall configuration of a light detecting system 2000 including the light detecting device (imaging device 1). FIG. 32B schematically illustrates an example of a circuit configuration of the light detecting system 2000. The light detecting system 2000 includes a light-emitting device 2001 as a light source unit that emits light L2 and a light detecting device 2002 as a light-receiving unit with a photoelectric conversion element.

The above-described light detecting device (imaging device 1) may be used as the light detecting device 2002. The light detecting system 2000 may further include a system control unit 2003, a light source drive unit 2004, a sensor control unit 2005, a light source side optical system 2006, and a camera side optical system 2007.

The light detecting device 2002 is able to detect light L1 and the light L2. The light L1 is reflected light of ambient light from the outside reflected by a subject (measurement target) 2100 (see FIG. 32A). The light L2 is light reflected by the subject 2100, of light beams emitted by the light-emitting device 2001. The light L1 is visible light, for example, and the light L2 is infrared light, for example.

The light L1 is detectable at a photoelectric conversion section in the light detecting device 2002, and the light L2 is detectable at the photoelectric conversion section in the light detecting device 2002. It is possible to acquire image information on the subject 2100 from the light L1 and to acquire information on a distance between the subject 2100 and the light detecting system 2000 from the light L2.

For example, the light detecting system 2000 can be mounted on an electronic apparatus such as a smartphone or on a mobile body such as a car. The light-emitting device 2001 can be configured using, for example, a semiconductor laser, a surface-emitting semiconductor laser, or a vertical resonator surface-emitting laser (VCSEL).

For example, an iTOF method can be employed as a method for the light detecting device 2002 to detect the light L2 emitted from the light-emitting device 2001; however, this is not limitative. In the iTOF method, the photoelectric conversion section is able to measure a distance to the subject 2100 by time of flight of light (Time-of-Flight; TOF), for example.

As a method for the light detecting device 2002 to detect the light L2 emitted from the light-emitting device 2001, it is possible to adopt, for example, a structured light method or a stereovision method. For example, in the structured light method, light having a predetermined pattern is projected on the subject 2100, and distortion of the pattern is analyzed, thereby making it possible to measure the distance between the light detecting system 2000 and the subject 2100.

In addition, in the stereovision method, for example, two or more cameras are used to acquire two or more images of the subject 2100 viewed from two or more different viewpoints, thereby making it possible to measure the distance between the light detecting system 2000 and the subject. It is to be noted that it is possible for the system control unit 2003 to synchronously control the light-emitting device 2001 and the light detecting device 2002.

### <4. Practical Application Examples>

### (Example of Practical Application to Mobile Body)

The technology (the present technology) according to the present disclosure is applicable to a variety of products. For example, the technology according to the present disclosure may be achieved as a device mounted on any type of mobile body such as an automobile, an electric vehicle, a hybrid electric vehicle, a motorcycle, a bicycle, a personal mobility, an aircraft, a drone, a vessel, or a robot.

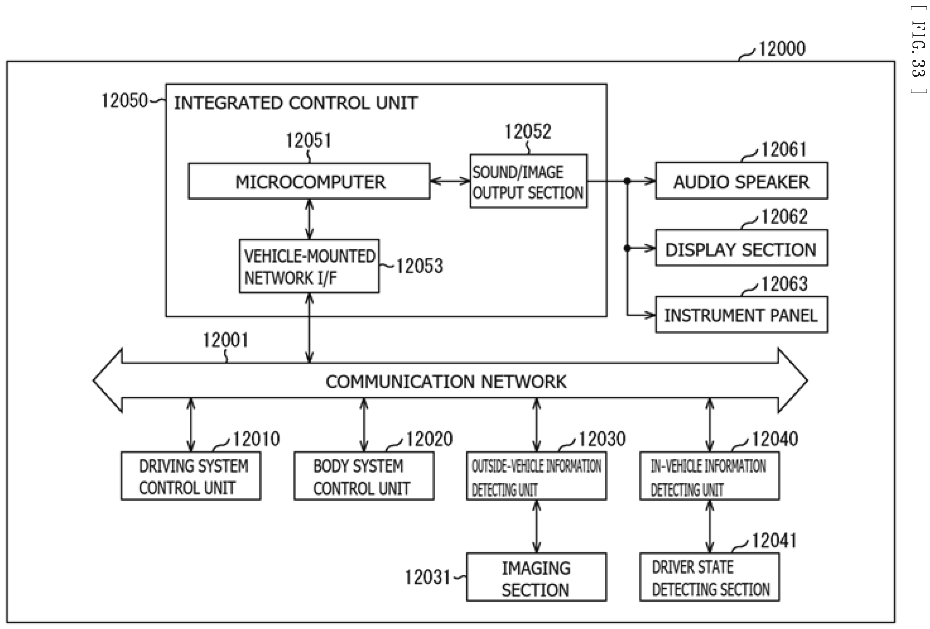

FIG. 33 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 33, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 33, an audio speaker 12061, a display section 12062, and an instrument panel 12063 are illustrated as the output device. The display section 12062 may, for example, include at least one of an on-board display and a head-up display.

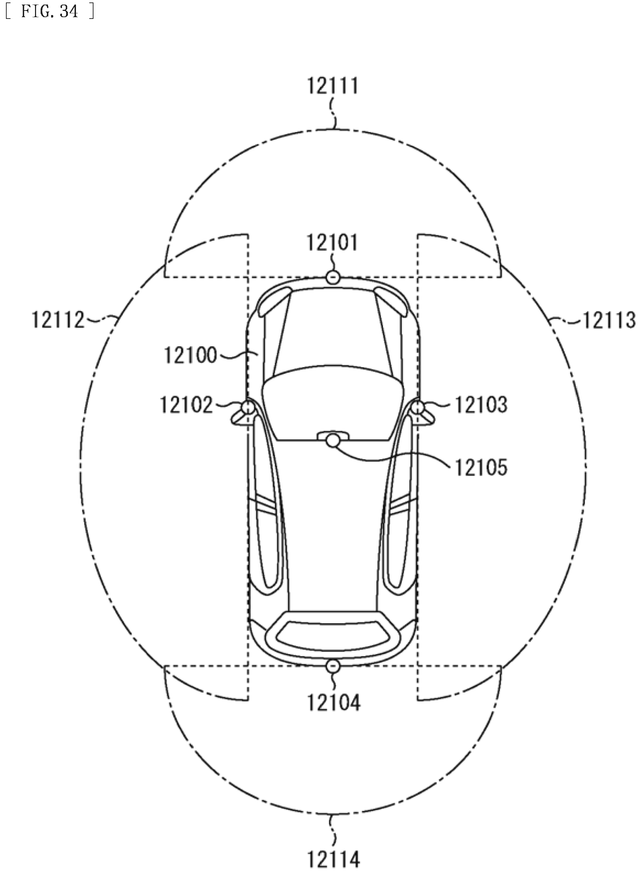

FIG. 34 is a diagram depicting an example of the installation position of the imaging section 12031.

In FIG. 34, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 34 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The description has been given hereinabove of the mobile body control system to which the technology according to an embodiment of the present disclosure is applicable. The technology according to an embodiment of the present disclosure is applicable to the imaging section 12031, for example, of the configurations described above. Specifically, for example, the imaging device 1 or the like can be applied to the imaging section 12031. Applying the technology according to an embodiment of the present disclosure to the imaging section 12031 enables obtainment of a photographed image having high definition. It becomes possible to perform highly accurate control utilizing the photographed image in the mobile body control system.

### (Example of Practical Application to Endoscopic Surgery System)

The technology according to an embodiment of the present disclosure (present technology) is applicable to various products. For example, the technology according to an embodiment of the present disclosure may be applied to an endoscopic surgery system.

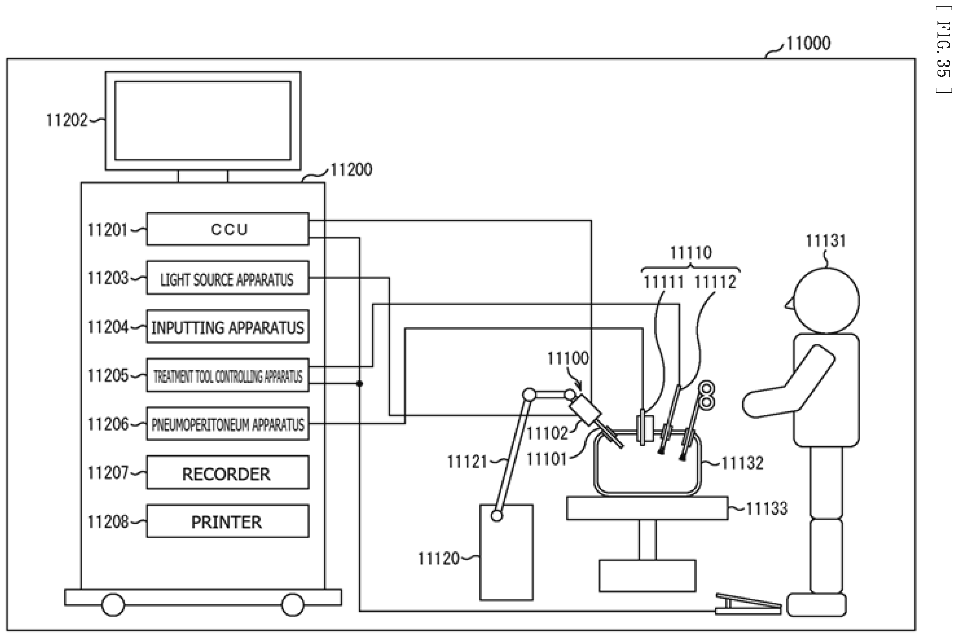

FIG. 35 is a view depicting an example of a schematic configuration of an endoscopic surgery system to which the technology according to an embodiment of the present disclosure (present technology) can be applied.

In FIG. 35, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photoelectrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

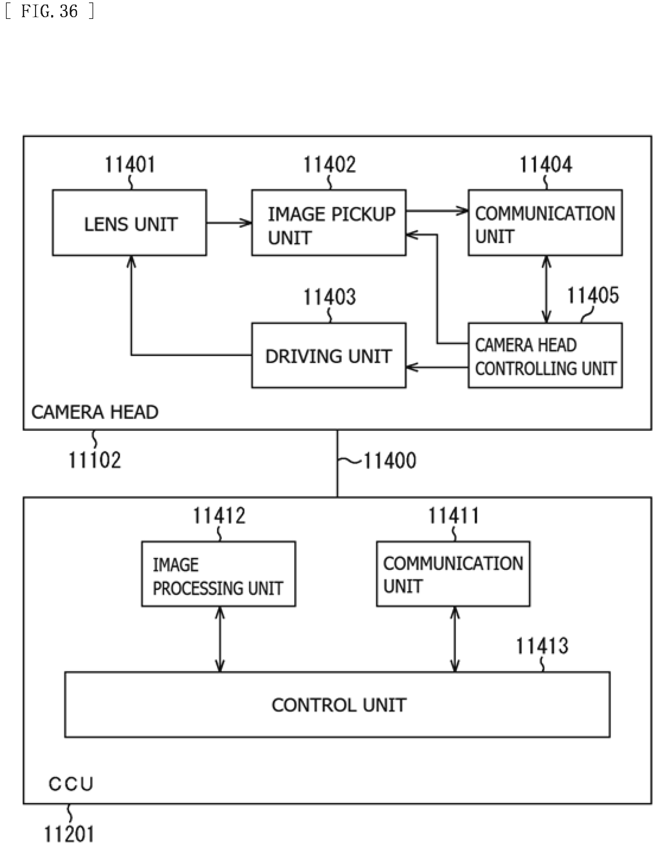

FIG. 36 is a block diagram depicting an example of a functional configuration of the camera head 11102 and the CCU 11201 depicted in FIG. 35.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

The description has been given hereinabove of one example of the endoscopic surgery system, to which the technology according to an embodiment of the present disclosure is applicable. The technology according to an embodiment of the present disclosure is suitably applicable to, for example, the image pickup unit 11402 provided in the camera head 11102 of the endoscope 11100 of the configurations described above. Applying the technology according to an embodiment of the present disclosure to the image pickup unit 11402 makes it possible to provide the endoscope 11100 having high definition.

Although the description has been given hereinabove of the present disclosure with reference to the embodiments, the modification examples, the application examples, and the practical application examples, the present technology is not limited to the foregoing embodiments and the like, and may be modified in a wide variety of ways. For example, although the foregoing modification examples have been described as modification examples of the foregoing embodiments, the configurations of the respective modification examples may be combined as appropriate.

In the foregoing embodiments and the like, the imaging device has been exemplified for description. However, it is sufficient for the light detecting device of the present disclosure to be, for example, a device that receives incident light and converts the light into electric charge. A signal to be outputted may be a signal of image information or a signal of information on a measured distance. The light detecting device (imaging device) is applicable to an image sensor, a distance measurement sensor, or the like. It is to be noted that the present disclosure is not limited to a back side illumination image sensor, and is also applicable to a front side illumination image sensor.

The light detecting device according to the present disclosure is also applicable as a distance measurement sensor that enables distance measurement of a TOF (Time Of Flight) method. The light detecting device (imaging device) is also applicable as a sensor that is able to detect an event, e.g., an event-driven sensor (referred to as EVS (Event Vision Sensor), EDS (Event Driven Sensor), DVS (Dynamic Vision Sensor), etc.).

The light detecting device according to an embodiment of the present disclosure includes: a first electrode; a second electrode provided to be opposed to the first electrode; a photoelectric conversion film provided between the first electrode and the second electrode; a first semiconductor layer provided between the photoelectric conversion film and the second electrode; and a second semiconductor layer provided between the first semiconductor layer and the second electrode. A difference between a Fermi level and an energy level at a conduction band lower end in the first semiconductor layer is smaller than a difference between a Fermi level and an energy level at a conduction band lower end in the second semiconductor layer. This makes it possible to achieve a light detecting device that makes it possible to suppress a decrease in signal quality.

The light detecting device according to an embodiment of the present disclosure includes: a first electrode; a second electrode provided to be opposed to the first electrode; a photoelectric conversion film provided between the first electrode and the second electrode; a first semiconductor layer provided between the photoelectric conversion film and the second electrode; and a second semiconductor layer provided between the first semiconductor layer and the second electrode. A carrier concentration in the first semiconductor layer is higher than a carrier concentration in the second semiconductor layer. This makes it possible to achieve a light detecting device that makes it possible to suppress a decrease in signal quality.

It is to be noted that the effects described herein are merely exemplary and are not limited to the description, and may further include other effects. In addition, the present disclosure may also have the following configurations.
(1) A light detecting device including:
   a first electrode;
   a second electrode provided to be opposed to the first electrode;
   a photoelectric conversion film provided between the first electrode and the second electrode;
   a first semiconductor layer provided between the photoelectric conversion film and the second electrode; and
   a second semiconductor layer provided between the first semiconductor layer and the second electrode, in which
   a difference between a Fermi level and an energy level at a conduction band lower end in the first semiconductor layer is smaller than a difference between a Fermi level and an energy level at a conduction band lower end in the second semiconductor layer.
(2) The light detecting device according to (1), in which the first semiconductor layer includes a semiconductor layer including an oxide semiconductor.
(3) The light detecting device according to (1) or (2), in which the second semiconductor layer includes a semiconductor layer including an oxide semiconductor.
(4) The light detecting device according to any one of (1) to (3), in which each of the first semiconductor layer and the second semiconductor layer includes an oxide semiconductor layer containing at least one of In, Ga, Zn, Ti, Sn, Si, Cu, Sb, or Cd.
(5) The light detecting device according to any one of (1) to (4), in which
   each of the first semiconductor layer and the second semiconductor layer includes an oxide semiconductor layer containing In, and
   an In composition ratio in the first semiconductor layer is larger than an In composition ratio in the second semiconductor layer.
(6) The light detecting device according to any one of (1) to (5), in which
   each of the first semiconductor layer and the second semiconductor layer includes an oxide semiconductor layer containing Zn, and
   a Zn composition ratio in the first semiconductor layer is larger than a Zn composition ratio in the second semiconductor layer.
(7) The light detecting device according to any one of (1) to (6), in which
   each of the first semiconductor layer and the second semiconductor layer includes a semiconductor layer including an oxide semiconductor, and
   a constituent element of the first semiconductor layer and a constituent element of the second semiconductor layer are different from each other.
(8) The light detecting device according to any one of (1) to (7), in which the first semiconductor layer contains an element different from a constituent element of the second semiconductor layer.
(9) The light detecting device according to any one of (1) to (8), in which the difference between the Fermi level and the energy level at the conduction band lower end in the second semiconductor layer is larger, by 0.02 eV or more, than the difference between the Fermi level and the energy level at the conduction band lower end in the first semiconductor layer.
(10) The light detecting device according to any one of (1) to (9), in which a difference between a vacuum level and the energy level at the conduction band lower end in the first semiconductor layer is larger than a difference between a vacuum level and the energy level at the conduction band lower end in the second semiconductor layer.
(11) The light detecting device according to any one of (1) to (10), further including a protective layer provided between the photoelectric conversion film and the first semiconductor layer, the protective layer including an inorganic material.
(12) The light detecting device according to (11), in which the protective layer includes a layer containing at least one of Ti, Si, Zr, Nb, V, Ta, Hf, Al, Sn, Sc, Y, La, Ga, or Mg.
(13) The light detecting device according to (11) or (12), in which a difference between a vacuum level and an energy level at a conduction band lower end of the protective layer is smaller than a difference between a vacuum level and the energy level at the conduction band lower end of the first semiconductor layer.
(14) The light detecting device according to any one of (11) to (13), in which the protective layer has a thickness of 5 nm or less.
(15) The light detecting device according to any one of (11) to (14), in which the first semiconductor layer includes a cation constituting the protective layer.
(16) The light detecting device according to any one of (1) to (15), in which a difference between a vacuum level and an energy level at a conduction band lower end in the photoelectric conversion film on a side of the first semiconductor layer is larger than a difference between a vacuum level and an energy level at a conduction band lower end in the first semiconductor layer on a side of the photoelectric conversion film.
(17) The light detecting device according to any one of (1) to (16), further including a first protective layer provided between the photoelectric conversion film and the first semiconductor layer, the first protective layer including an inorganic material, in which
   a difference between a vacuum level and an energy level at a conduction band lower end in the first protective layer on a side of the first semiconductor layer is larger than a difference between a vacuum level and an energy level at a conduction band lower end in the first semiconductor layer on a side of the first protective layer.
(18) The light detecting device according to (17), further including a second protective layer provided between the first protective layer and the first semiconductor layer, the second protective layer including an inorganic material, in which
   a difference between a vacuum level and an energy level at a conduction band lower end of the second protective layer is smaller than the difference between the vacuum level and the energy level at the conduction band lower end of the first semiconductor layer.
(19) The light detecting device according to (18), in which the second protective layer has a thickness of 5 nm or less.
(20) The light detecting device according to (18) or (19), in which each of the first protective layer and the second protective layer includes a layer containing at least one of Ti, Si, Zr, Nb, V, Ta, Hf, Al, Sn, Sc, Y, La, Ga, or Mg.
(21) The light detecting device according to any one of (1) to (20), in which the first semiconductor layer has a thickness of 10 nm or less.
(22) The light detecting device according to any one of (1) to (21), further including a third electrode provided around the second electrode in a direction orthogonal to a thickness direction of the second semiconductor layer, in which
   the first semiconductor layer is provided, in a plan view, to overlap the second electrode, among the second electrode and the third electrode.
(23) The light detecting device according to any one of (1) to (22), in which a bandgap in the first semiconductor layer is smaller than a bandgap in the second semiconductor layer.
(24) The light detecting device according to (23), in which
   an energy level at a conduction band lower end in the photoelectric conversion film is larger than the energy level at the conduction band lower end in the first semiconductor layer, and
   the energy level at the conduction band lower end in the first semiconductor layer is larger than the energy level at the conduction band lower end in the second semiconductor layer.
(25) The light detecting device according to (23) or (24), further including a protective layer provided between the photoelectric conversion film and the first semiconductor layer, the protective layer including an inorganic material, in which
   an energy level at a valence band upper end in the protective layer is larger than an energy level at a valence band upper end in the first semiconductor layer.
(26) An electronic apparatus including:
   an optical system; and
   a light detecting device that receives light transmitted through the optical system,
   the light detecting device including
      a first electrode,
      a second electrode provided to be opposed to the first electrode,
   a photoelectric conversion film provided between the first electrode and the second electrode,
      a first semiconductor layer provided between the photoelectric conversion film and the second electrode, and
      a second semiconductor layer provided between the first semiconductor layer and the second electrode, in which
   a difference between a Fermi level and an energy level at a conduction band lower end in the first semiconductor layer is smaller than a difference between a Fermi level and an energy level at a conduction band lower end in the second semiconductor layer.
(27) A light detecting device including:
   a first electrode;
   a second electrode provided to be opposed to the first electrode;
   a photoelectric conversion film provided between the first electrode and the second electrode;
   a first semiconductor layer provided between the photoelectric conversion film and the second electrode; and
   a second semiconductor layer provided between the first semiconductor layer and the second electrode, in which
   a carrier concentration in the first semiconductor layer is higher than a carrier concentration in the second semiconductor layer.
(28) The light detecting device according to (27), in which the first semiconductor layer includes a semiconductor layer including an oxide semiconductor.
(29) The light detecting device according to (27) or (28), in which the second semiconductor layer includes a semiconductor layer including an oxide semiconductor.
(30) The light detecting device according to any one of (27) to (29), in which the carrier concentration of the first semiconductor layer is 1 × 10¹⁸ cm⁻³ or more.
(31) The light detecting device according to any one of (27) to (30), in which the carrier concentration of the second semiconductor layer is less than 1 × 10¹⁸ cm⁻³.
(32) The light detecting device according to any one of (27) to (31), in which each of the first semiconductor layer and the second semiconductor layer includes an oxide semiconductor layer containing at least one of In, Ga, Zn, Ti, Sn, Si, Cu, Sb, or Cd.
(33) The light detecting device according to any one of (27) to (32), in which
   each of the first semiconductor layer and the second semiconductor layer includes an oxide semiconductor layer containing In, and
   an In composition ratio in the first semiconductor layer is larger than an In composition ratio in the second semiconductor layer.
(34) The light detecting device according to any one of (27) to (33), in which
   each of the first semiconductor layer and the second semiconductor layer includes an oxide semiconductor layer containing Zn, and
   a Zn composition ratio in the first semiconductor layer is larger than a Zn composition ratio in the second semiconductor layer.
(35) The light detecting device according to any one of (27) to (34), in which
   each of the first semiconductor layer and the second semiconductor layer includes a semiconductor layer including an oxide semiconductor, and
   a constituent element of the first semiconductor layer and a constituent element of the second semiconductor layer are different from each other.
(36) The light detecting device according to any one of (27) to (35), in which the first semiconductor layer contains an element different from a constituent element of the second semiconductor layer.
(37) The light detecting device according to any one of (27) to (36), further including a protective layer provided between the photoelectric conversion film and the first semiconductor layer, the protective layer including an inorganic material.
(38) The light detecting device according to (37), in which the protective layer includes a layer containing at least one of Ti, Si, Zr, Nb, V, Ta, Hf, Al, Sn, Sc, Y, La, Ga, or Mg.
(39) The light detecting device according to (37) or (38), in which a difference between a vacuum level and an energy level at a conduction band lower end of the protective layer is smaller than a difference between a vacuum level and an energy level at a conduction band lower end of the first semiconductor layer.
(40) The light detecting device according to any one of (37) to (39), in which the protective layer has a thickness of 5 nm or less.
(41) The light detecting device according to any one of (37) to (40), in which the first semiconductor layer includes a cation constituting the protective layer.
(42) The light detecting device according to any one of (27) to (41), in which a difference between a vacuum level and an energy level at a conduction band lower end in the photoelectric conversion film on a side of the first semiconductor layer is larger than a difference between a vacuum level and an energy level at a conduction band lower end in the first semiconductor layer on a side of the photoelectric conversion film.
(43) The light detecting device according to any one of (27) to (42), further including a first protective layer provided between the photoelectric conversion film and the first semiconductor layer, the first protective layer including an inorganic material, in which
   a difference between a vacuum level and an energy level at a conduction band lower end in the first protective layer on a side of the first semiconductor layer is larger than a difference between a vacuum level and an energy level at a conduction band lower end in the first semiconductor layer on a side of the first protective layer.
(44) The light detecting device according to (43), further including a second protective layer provided between the first protective layer and the first semiconductor layer, the second protective layer including an inorganic material, in which
   a difference between a vacuum level and an energy level at a conduction band lower end of the second protective layer is smaller than the difference between the vacuum level and the energy level at the conduction band lower end of the first semiconductor layer.
(45) The light detecting device according to (44), in which the second protective layer has a thickness of 5 nm or less.
(46) The light detecting device according to (44) or (45), in which each of the first protective layer and the second protective layer includes a layer containing at least one of Ti, Si, Zr, Nb, V, Ta, Hf, Al, Sn, Sc, Y, La, Ga, or Mg.
(47) The light detecting device according to any one of (27) to (46), in which the first semiconductor layer has a thickness of 10 nm or less.
(48) The light detecting device according to any one of (27) to (47), further including a third electrode provided around the second electrode in a direction orthogonal to a thickness direction of the second semiconductor layer, in which
   the first semiconductor layer is provided, in a plan view, to overlap the second electrode, among the second electrode and the third electrode.
(49) The light detecting device according to any one of (27) to (48), in which a bandgap in the first semiconductor layer is smaller than a bandgap in the second semiconductor layer.
(50) The light detecting device according to (49), in which
   an energy level at a conduction band lower end in the photoelectric conversion film is larger than the energy level at the conduction band lower end in the first semiconductor layer, and
   the energy level at the conduction band lower end in the first semiconductor layer is larger than the energy level at the conduction band lower end in the second semiconductor layer.
(51) The light detecting device according to (49) or (50), further including a protective layer provided between the photoelectric conversion film and the first semiconductor layer, the protective layer including an inorganic material, in which
   an energy level at a valence band upper end in the protective layer is larger than an energy level at a valence band upper end in the first semiconductor layer.
(52) An electronic apparatus including:
   an optical system; and
   a light detecting device that receives light transmitted through the optical system,
   the light detecting device including
      a first electrode,
      a second electrode provided to be opposed to the first electrode,
   a photoelectric conversion film provided between the first electrode and the second electrode,
      a first semiconductor layer provided between the photoelectric conversion film and the second electrode, and
      a second semiconductor layer provided between the first semiconductor layer and the second electrode, in which
   a carrier concentration in the first semiconductor layer is higher than a carrier concentration in the second semiconductor layer.

The present application claims the benefit of Japanese Priority Patent Application JP2023-210156 filed with the Japan Patent Office on December 13, 2023, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. A light detecting device comprising:
a first electrode;
a second electrode provided to be opposed to the first electrode;
a photoelectric conversion film provided between the first electrode and the second electrode;
a first semiconductor layer provided between the photoelectric conversion film and the second electrode; and
a second semiconductor layer provided between the first semiconductor layer and the second electrode, wherein
a difference between a Fermi level and an energy level at a conduction band lower end in the first semiconductor layer is smaller than a difference between a Fermi level and an energy level at a conduction band lower end in the second semiconductor layer.

2. The light detecting device according to claim 1, wherein the first semiconductor layer comprises a semiconductor layer including an oxide semiconductor.

3. The light detecting device according to claim 2, wherein the second semiconductor layer comprises a semiconductor layer including an oxide semiconductor.

4. The light detecting device according to claim 1, wherein each of the first semiconductor layer and the second semiconductor layer comprises an oxide semiconductor layer containing at least one of In, Ga, Zn, Ti, Sn, Si, Cu, Sb, or Cd.

5. The light detecting device according to claim 1, wherein
each of the first semiconductor layer and the second semiconductor layer comprises an oxide semiconductor layer containing In, and
an In composition ratio in the first semiconductor layer is larger than an In composition ratio in the second semiconductor layer.

6. The light detecting device according to claim 1, wherein
each of the first semiconductor layer and the second semiconductor layer comprises an oxide semiconductor layer containing Zn, and
a Zn composition ratio in the first semiconductor layer is larger than a Zn composition ratio in the second semiconductor layer.

7. The light detecting device according to claim 1, wherein
each of the first semiconductor layer and the second semiconductor layer comprises a semiconductor layer including an oxide semiconductor, and
a constituent element of the first semiconductor layer and a constituent element of the second semiconductor layer are different from each other.

8. The light detecting device according to claim 1, wherein the first semiconductor layer contains an element different from a constituent element of the second semiconductor layer.

9. The light detecting device according to claim 1, wherein the difference between the Fermi level and the energy level at the conduction band lower end in the second semiconductor layer is larger, by 0.02 eV or more, than the difference between the Fermi level and the energy level at the conduction band lower end in the first semiconductor layer.

10. The light detecting device according to claim 1, wherein a difference between a vacuum level and the energy level at the conduction band lower end in the first semiconductor layer is larger than a difference between a vacuum level and the energy level at the conduction band lower end in the second semiconductor layer.

11. The light detecting device according to claim 1, further comprising a protective layer provided between the photoelectric conversion film and the first semiconductor layer, the protective layer including an inorganic material.

12. The light detecting device according to claim 11, wherein the protective layer comprises a layer containing at least one of Ti, Si, Zr, Nb, V, Ta, Hf, Al, Sn, Sc, Y, La, Ga, or Mg.

13. The light detecting device according to claim 11, wherein a difference between a vacuum level and an energy level at a conduction band lower end of the protective layer is smaller than a difference between a vacuum level and the energy level at the conduction band lower end of the first semiconductor layer.

14. The light detecting device according to claim 11, wherein the protective layer has a thickness of 5 nm or less.

15. The light detecting device according to claim 11, wherein the first semiconductor layer includes a cation constituting the protective layer.

16. The light detecting device according to claim 1, wherein a difference between a vacuum level and an energy level at a conduction band lower end in the photoelectric conversion film on a side of the first semiconductor layer is larger than a difference between a vacuum level and an energy level at a conduction band lower end in the first semiconductor layer on a side of the photoelectric conversion film.

17. The light detecting device according to claim 1, further comprising a first protective layer provided between the photoelectric conversion film and the first semiconductor layer, the first protective layer including an inorganic material, wherein
a difference between a vacuum level and an energy level at a conduction band lower end in the first protective layer on a side of the first semiconductor layer is larger than a difference between a vacuum level and an energy level at a conduction band lower end in the first semiconductor layer on a side of the first protective layer.

18. The light detecting device according to claim 17, further comprising a second protective layer provided between the first protective layer and the first semiconductor layer, the second protective layer including an inorganic material, wherein
a difference between a vacuum level and an energy level at a conduction band lower end of the second protective layer is smaller than the difference between the vacuum level and the energy level at the conduction band lower end of the first semiconductor layer.

19. The light detecting device according to claim 18, wherein the second protective layer has a thickness of 5 nm or less.

20. The light detecting device according to claim 18, wherein each of the first protective layer and the second protective layer comprises a layer containing at least one of Ti, Si, Zr, Nb, V, Ta, Hf, Al, Sn, Sc, Y, La, Ga, or Mg.

21. The light detecting device according to claim 1, wherein the first semiconductor layer has a thickness of 10 nm or less.

22. The light detecting device according to claim 1, further comprising a third electrode provided around the second electrode in a direction orthogonal to a thickness direction of the second semiconductor layer, wherein
the first semiconductor layer is provided, in a plan view, to overlap the second electrode, among the second electrode and the third electrode.

23. The light detecting device according to claim 1, wherein a bandgap in the first semiconductor layer is smaller than a bandgap in the second semiconductor layer.

24. The light detecting device according to claim 23, wherein
an energy level at a conduction band lower end in the photoelectric conversion film is larger than the energy level at the conduction band lower end in the first semiconductor layer, and
the energy level at the conduction band lower end in the first semiconductor layer is larger than the energy level at the conduction band lower end in the second semiconductor layer.

25. The light detecting device according to claim 23, further comprising a protective layer provided between the photoelectric conversion film and the first semiconductor layer, the protective layer including an inorganic material, wherein
an energy level at a valence band upper end in the protective layer is larger than an energy level at a valence band upper end in the first semiconductor layer.

26. An electronic apparatus comprising:
an optical system; and
a light detecting device that receives light transmitted through the optical system,
the light detecting device including
a first electrode,
a second electrode provided to be opposed to the first electrode,
a photoelectric conversion film provided between the first electrode and the second electrode,
a first semiconductor layer provided between the photoelectric conversion film and the second electrode, and
a second semiconductor layer provided between the first semiconductor layer and the second electrode, wherein
a difference between a Fermi level and an energy level at a conduction band lower end in the first semiconductor layer is smaller than a difference between a Fermi level and an energy level at a conduction band lower end in the second semiconductor layer.
